# EUROPEAN PATENT APPLICATION

(11) **EP 4 772 791 A1**
(43) Date of publication of application: **08.07.2026**
(21) Application number: 24860348.2
(22) Date of filing: 26.08.2024
(51) Int. Cl.: F21V 29/51, F21V 29/74, F21V 29/56, F21V 29/60, F21V 29/80, F21V 29/89, F21V 29/83, F21V 29/71, H05K 7/20, F21Y 115/10

(54) **LIGHTING APPARATUS**

(30) Priority: 28.08.2023 KR 20230112781; 16.10.2023 KR 20230137769; 29.12.2023 KR 20230196873; 16.04.2024 KR 20240050967
(71) Applicant: Gigatera Lighting Inc., Hwaseong-si, Gyeonggi-do 18462 (KR)
(72) Inventor: HAN, Yong Hee, Osan-si Gyeonggi-do 18114 (KR); CHOI, Pyoung Hwa, Hwaseong-si Gyeonggi-do 18476 (KR); LIM, Chang Gyu, Osan-si Gyeonggi-do 18146 (KR)
(74) Representative: impuls legal PartG mbB
(86) International application number: PCT/KR2024/012685
(87) International publication number: WO 2025/048428

(57) **Abstract**

The present invention relates to a lighting apparatus. More specifically, the lighting apparatus comprises: an LED unit in which one of two surfaces forms a radiation surface having a plurality of LED elements mounted thereon and radiating light, and the other of the two surfaces forms a heating surface for emitting predetermined heat; a plurality of cooling units which are arranged vertically in the direction of gravity with respect to the heating surface of the LED unit and spaced a predetermined distance from each other in the left-right direction, and which have therein a refrigerant flow space filled with a phase-changeable refrigerant; and a lighting body in which the LED unit and the plurality of cooling units are installed, and a portion in the direction of the radiation surface is open. As a result, the lighting apparatus provides the advantage of maximizing cooling performance.

## Description

### [Technical Field]

The present disclosure relates to a lighting apparatus, and more particularly, to a lighting apparatus that can maximize heat dissipation performance by including a heat dissipation unit capable of effectively dissipating heat generated from an LED unit.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a cooling system at an appropriate level should be accompanied therewith.

The cooling system is used in various industries, including air conditioners, mobile communications, data centers, air mobility, electric vehicles, energy storage devices, and displays. Such a cooling system is one of the major causes of power consumption, and the power consumption is gradually increasing as industries continue to develop.

In general, a cooling device may be broadly classified into an active cooling device and a passive cooling device. The active cooling device mainly utilizes forced convection generated by a fan, whereas the passive cooling device may be classified as a technology that utilizes natural convection without using a fan.

However, a conventional cooling system has limitations in dissipating a high level of heat generated by continuously developing and advanced technologies. Thus, there is a need in related industrial fields for innovative technologies capable of solving these problems, and as part of efforts to solve them, heat dissipation mechanisms are being developed.

A phase change refers to a change in the inherent state of liquid, gas, or solid when it accumulates a large amount of energy or releases stored thermal energy.

The phase change refers to a change in the physical arrangement of molecules rather than a chemical reaction such as chemical bonding or formation. The heat in a state in which no phase change occurs when energy is applied to a substance is referred to as sensible heat, whereas the heat used during a phase change is referred to as latent heat.

However, the heat dissipation mechanism has a problem in that pressure increases as temperature rises, because temperature and pressure are proportional to each other. When pressure increases due to high temperature conducted from a heating element within the sealed heat dissipation mechanism, it may cause the heat dissipation mechanism itself to rupture. To address this problem, it is necessary to prevent the pressure from increasing, and the heat dissipation mechanism requires a sufficient internal volume to allow pressure equilibrium to be achieved during the phase-change circulation process of a substance.

In addition, the refrigerant filled in the heat dissipation mechanism also needs to be selected as a type that does not cause a chemical reaction with a metal material of the heat dissipation mechanism, so as to prevent an increase in internal pressure of the heat dissipation mechanism.

For example, when a metal material constituting the heat dissipation mechanism is aluminum (Al) and water is selected as the refrigerant, an oxidation reaction occurs between water and aluminum at an initial stage of refrigerant charging to generate aluminum oxide, and during that process, a portion is substituted with hydrogen, thereby causing a problem of increasing internal pressure. Thus, in a heat dissipation mechanism made of aluminum, a special refrigerant such as a Honeywell refrigerant or CFC (Freon gas) for preventing such a chemical reaction is generally selected.

However, in recent years, many countries have tended to regulate the use of special refrigerants such as Honeywell refrigerants or CFCs (Freon gas), excluding water. As described above, such special refrigerants may leak to the outside in the event of damage caused by an increase in internal pressure of the heat dissipation mechanism or damage during transportation, transfer, or installation of a product. In this case, there is a problem in that they may contaminate the atmosphere and the external environment.

However, when special refrigerants are excluded as usable refrigerants, the use of the heat dissipation mechanism made of aluminum, which is commonly used due to its higher thermal conductivity compared to other metal materials, may inevitably be limited. Thus, in the related heat-dissipation-mechanism manufacturing industry, active research has recently been conducted on substituting the metal material constituting the heat dissipation mechanism and on heat dissipation design.

Meanwhile, as research material related to the above-described drawbacks, a paper by co-author Liqiang Deng published in the International Journal of Thermal Sciences (issued on August 15, 2022, hereinafter referred to as the "prior paper"), entitled "Thermal study of the natural air cooling using roll bond flat heat pipe as plate fin under multi-heat source condition," is briefly introduced as follows.

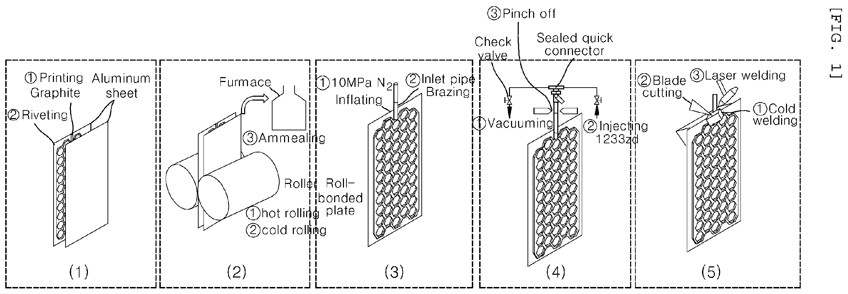

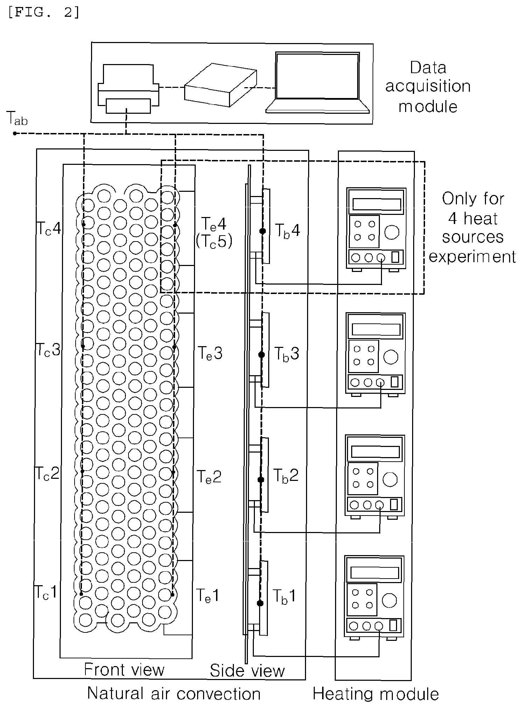

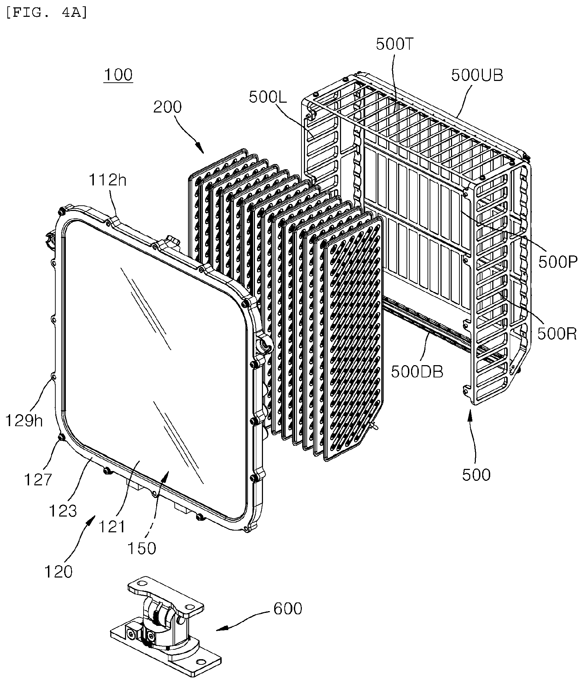

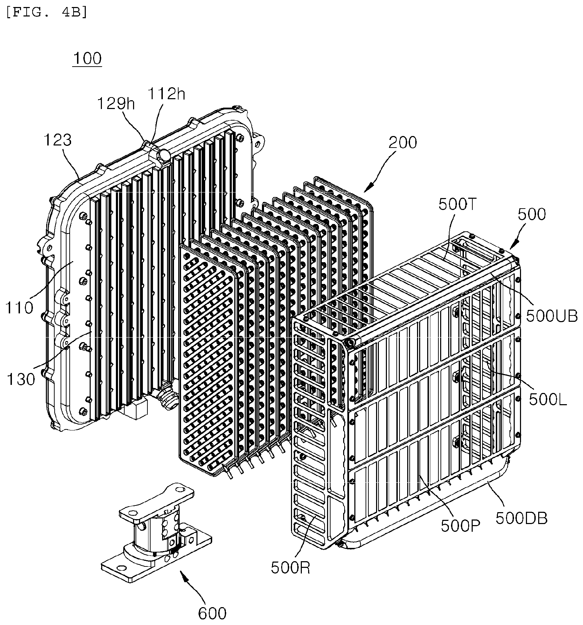

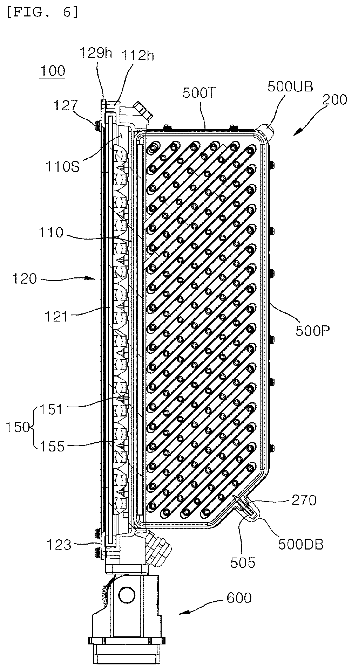

FIG. 1 is a schematic diagram illustrating a manufacturing process of a Roll Bond Flat Heat Pipe (hereinafter abbreviated as "RBFHP") published in the prior paper (see FIG. 4 of the prior paper), and FIG. 2 is a schematic view illustrating an overview of a test device of the RBFHP of FIG. 1 (FIG. 6 of the prior paper).

As shown in FIG. 1, the RBFHP of the prior paper is manufactured by printing non-adhesive graphite on a first aluminum sheet using a pre-designed mold, stacking it on a second aluminum sheet, and then rolling and bonding the two aluminum sheets in the order of hot rolling, cold rolling, and annealing. Thereafter, an inlet pipe is soldered, and high-pressure gas is injected from an inlet into a plate to inflate non-bonded portions, thereby forming self-connected chambers.

The prior paper concludes that the RBFHP formed as described above exhibits better results than a general aluminum plate (fin) under test conditions shown in FIG. 2 (a test with four evenly distributed heat sources).

However, since the RBFHP of the prior paper is manufactured by a roll bonding method as described above, there is a problem in that it is difficult for the refrigerant (particularly, liquid refrigerant) to be disposed in proximity to a joined end (i.e., peripheral edge) located closest to a heat source.

That is, in the roll bonding method, the peripheral edge is inevitably joined, and at least a portion where bonding is overlapped should be spaced apart from the heat source (heating element), thereby causing thermal conduction resistance due to the material properties of the material itself.

The reason why the manufacturing method of the RBFHP in the prior paper is limited to or adopted as the roll bonding method is considered to be attributable to the fact that it is an optimal method for forming an internal chamber using two aluminum panel sheets, and it appears to have been inevitably adopted because the aluminum sheets themselves are practically impossible to process by a bending method.

Meanwhile, the RBFHP of the prior paper has a honeycomb structure to maximize an area when the refrigerant vaporized near the heat source moves to a condensation region where it is condensed. However, it is expected that not only does a flow path through which the gas refrigerant rapidly moves to an upper end farthest from the heat source become longer, but also a large flow resistance occurs as a return path of the liquid refrigerant condensed in the condensation region overlaps with the flow path of the gas refrigerant.

In particular, in a lighting apparatus, elements (e.g., LED units) that generate light by receiving electrical energy produce a large amount of heat due to electrical resistance during operation, and the rapid dissipation of the generated heat greatly affects the performance and lifespan of the lighting apparatus. Therefore, the application of a more improved heat dissipation mechanism is required.

### [Disclosure]

### [Technical Problem]

The present disclosure is proposed to resolve the aforementioned technical issues and is directed to providing a lighting apparatus including a heat dissipation unit capable of effectively dissipating heat generated from an LED unit.

In addition, the present disclosure is directed to providing a lighting apparatus capable of significantly improving both heat dissipation performance and light distribution performance, since a heat dissipation area of an LED unit within a relatively narrow range may be increased through the above-described heat dissipation unit.

Further, the present disclosure is directed to providing a lighting apparatus capable of preventing an increase in product size by preventing a temperature deviation between LED elements even when the plurality of LED elements are closely spaced.

Further, the present disclosure is directed to providing a lighting apparatus capable of preventing deterioration of light distribution performance by enabling a plurality of LED elements constituting an LED unit to be densely arranged.

Technical issues of the present disclosure are not limited to the technical issues mentioned above, and other technical issues not mentioned above will be clearly understood by those skilled in the art from the following description.

### [Technical Solution]

A lighting apparatus according to an embodiment of the present disclosure includes an LED unit having a plurality of LED elements mounted on one surface of opposite surfaces to define a light-emitting surface from which light is radiated, the other surface defining a heat-generating surface to release a predetermined amount of heat, a plurality of heat dissipation units respectively disposed vertically in an up-and-down direction along a direction of gravity with respect to the heat-generating surface of the LED unit, spaced apart from each other by a predetermined distance in a left-and-right direction, and having a refrigerant flow space formed therein and filled with a phase-changeable refrigerant, and a lighting body in which the LED unit and the plurality of heat dissipation units are installed and which is opened at a portion in the direction of the light-emitting surface.

The plurality of heat dissipation units may receive heat from the LED unit via the lighting body in which the LED unit is installed and in which a plurality of press-fit portions are formed to extend in an up-and-down direction at positions corresponding to the heat-generating surface.

The plurality of heat dissipation units may be press-fitted and fixed to the press-fit portions such that at least a portion of the refrigerant flow space is positioned inside the plurality of press-fit portions provided with a pair of slot ribs.

The plurality of heat dissipation units may receive heat from the LED unit via a heat transfer mediating block having one surface in contact with the heat-generating surface of the LED unit and the other surface provided with an uneven portion that is in thermal contact with the refrigerant flow space.

The uneven portion of the heat transfer mediating block may be inserted from the outside toward the refrigerant flow space and be in contact with liquid refrigerant filled in the refrigerant flow space.

The refrigerant flow space of the plurality of heat dissipation units may include a first refrigerant flow path constituting an evaporation region that evaporates liquid refrigerant of refrigerant filled therein by heat transferred from the LED unit, and a plurality of second refrigerant flow paths provided in a condensation region in which gas refrigerant evaporated from the first refrigerant flow path diffuses and is condensed through heat exchange with outdoor air, the plurality of second refrigerant flow paths guiding a flow of the condensed liquid refrigerant toward the first refrigerant flow path.

The plurality of heat dissipation units may include a one-side heat conduction panel forming one side surface of the refrigerant flow space, and an other-side heat conduction panel forming the other side surface of the refrigerant flow space, and the one-side heat conduction panel and the other-side heat conduction panel may form the refrigerant flow space by bending and joining a single metal panel member, or may form the refrigerant flow space by joining two metal panel members.

The metal panel members forming the one-side heat conduction panel and the other-side heat conduction panel may be made of SUS (stainless steel).

When the metal panel members forming the one-side heat conduction panel and the other-side heat conduction panel are made of SUS, the refrigerant may be water.

The plurality of heat dissipation units may further include a plurality of strength reinforcing portions formed to protrude from the one-side heat conduction panel and the other-side heat conduction panel toward the refrigerant flow space, and the plurality of strength reinforcing portions may be joined to each other within the refrigerant flow space when the one-side heat conduction panel and the other-side heat conduction panel are joined together.

The plurality of heat dissipation units may further include an absorber disposed on the first refrigerant flow path in the refrigerant flow space to promote evaporation of liquid refrigerant of the refrigerant by heat supplied from the LED unit.

The absorber may be provided as either a braided body formed by braiding thermally conductive metal wires or a sintered body formed by sintering metal powder of a predetermined material.

When the absorber is provided as the sintered body, the metal powder forming the sintered body may be made of SUS, which forms the one-side heat conduction panel and the other-side heat conduction panel.

The plurality of heat dissipation units may further include an air vent tube for vacuumizing the refrigerant flow space before or after the refrigerant is injected into the refrigerant flow space.

The air vent tube may be coupled to either the one-side heat conduction panel or the other-side heat conduction panel, or be integrally formed with the one-side heat conduction panel and the other-side heat conduction panel.

The lighting apparatus may further include a finger guard panel assembly configured to cover the plurality of heat dissipation units except for the light-emitting surface of the LED unit, the finger guard panel assembly having a plurality of ventilation holes formed through which outdoor air is ventilated to enable heat exchange with the plurality of heat dissipation units.

### [Advantageous Effects]

In a lighting apparatus according to an embodiment of the present disclosure, a heat dissipation area of an LED unit in a narrow range can be increased through a heat dissipation unit having a refrigerant flow space filled with a phase-changeable refrigerant, thereby significantly improving both heat dissipation performance and light distribution performance.

In addition, the present disclosure can prevent an increase in product size by preventing a temperature deviation between LED elements even when the plurality of LED elements are closely spaced.

### [Description of Drawings]

FIG. 1 is a schematic diagram illustrating a manufacturing process of a Roll Bond Flat Heat Pipe (hereinafter abbreviated as "RBFHP") published in the prior paper (see FIG. 4 of the prior paper);
FIG. 2 is a schematic view illustrating an overview of a test device of the RBFHP of FIG. 1 (FIG. 6 of the prior paper);
FIGS. 3A and 3B are front and rear perspective views illustrating a lighting apparatus according to an embodiment of the present disclosure;
FIGS. 4A and 4B are exploded perspective views of FIGS. 3A and 3B, respectively, illustrating a state in which a heat dissipation unit is separated from a lighting body;
FIGS. 5A and 5B are exploded perspective views of FIGS. 3A and 3B, respectively, illustrating a state in which the heat dissipation unit is coupled to the lighting body;
FIG. 6 is a cross-sectional view taken along line A-A of FIG. 3A;
FIGS. 7A and 7B are front and rear perspective views illustrating the lighting body among components of FIGS. 3A and 3B;
FIGS. 8A and 8B are exploded perspective views of FIGS. 7A and 7B, respectively;
FIG. 9 is an exploded perspective view illustrating a state in which a heat dissipation unit according to a first implementation is installed on a rear portion of the lighting body;
FIG. 10 is a perspective view illustrating a heat dissipation unit according to a first implementation for dissipating heat of a lighting apparatus according to an embodiment of the present disclosure;
FIG. 11 is an exploded perspective view of FIG. 10;
FIG. 12 is a perspective view illustrating a state in which a one-side heat conduction panel among components of the heat dissipation unit of FIG. 10 is removed;
FIG. 13 is a cross-sectional view taken along line B-B of FIG. 10;
FIG. 14 is a perspective view illustrating an angle adjustment unit among the components of the lighting apparatus according to an embodiment of the present disclosure;
FIG. 15 is an exploded perspective view of FIG. 14;
FIGS. 16A and 16B are partial perspective views for explaining an operation state by tilting rotation and steering rotation of the angle adjustment unit;
FIG. 17 is a perspective view illustrating a lighting apparatus according to another embodiment of the present disclosure;
FIGS. 18A and 18B are front and rear exploded perspective views for explaining a finger guard panel assembly among components of FIG. 17;
FIG. 19 is a downward perspective view illustrating a lighting apparatus according to another embodiment of the present disclosure;
FIG. 20 is a perspective view illustrating a use example of a lighting apparatus according to another embodiment of the present disclosure;
FIG. 21 is an upward perspective view illustrating a lighting apparatus according to another embodiment of the present disclosure;
FIGS. 22A and 22B are downward and upward exploded perspective views illustrating a coupled state by an electronic-component storage frame and a tilting bracket portion among components of FIGS. 19 and 21;
FIGS. 23A and 23B are front and rear exploded perspective views illustrating the electronic-component storage frame among the components of FIGS. 19 and 21;
FIGS. 24A and 24B are front and rear exploded perspective views illustrating a finger guard panel assembly among the components of FIGS. 19 and 21;
FIGS. 25A and 25B are front and rear perspective views illustrating a lighting apparatus according to another embodiment of the present disclosure;
FIGS. 26A and 26B are front and rear exploded perspective views illustrating an electronic-component storage frame implemented according to another implementation among components of FIGS. 25A and 25B;
FIGS. 27A and 27B are front and rear exploded perspective views illustrating a finger guard panel assembly implemented according to another implementation among the components of FIGS. 25A and 25B;
FIGS. 28A and 28B are downward and upward perspective views illustrating a state in which the finger guard panel assembly is excluded among the components of FIGS. 19 and 21;
FIGS. 29A and 29B are exploded perspective views of FIGS. 28A and 28B;
FIGS. 30A and 30B are downward and upward perspective views illustrating a state in which a lighting body and a blower unit are excluded among the components of FIGS. 28A and 28B;
FIGS. 31A and 31B are exploded perspective views of FIGS. 30A and 30B, respectively, illustrating an exploded state of an LED unit;
FIGS. 32A and 32B are front and rear perspective views illustrating a coupled state of an LED unit to a single heat dissipation unit among the components of FIGS. 30A and 30B;
FIGS. 33A and 33B are exploded perspective views of FIGS. 32A and 32B;
FIGS. 34A to 34C are perspective views from various directions of a heat dissipation unit according to a second implementation among the components of FIG. 19;
FIGS. 35A to 35C are exploded perspective views of FIGS. 34A to 34C;
FIG. 36A is a side view (a) of FIG. 34A, a cross-sectional view (b) taken along line A-A, and a partially enlarged view (c) thereof;
FIG. 36B is a side view (a) of FIG. 34A, a cutaway perspective view (b) taken along line A-A, and a partially enlarged view (c) thereof;
FIG. 37A is a vertical cross-sectional view taken along line B-B of FIG. 19;
FIG. 37B is a cutaway perspective view taken along line B-B of FIG. 19;
FIG. 38 is a perspective view illustrating a lighting apparatus to which a heat dissipation unit according to a third implementation is applied among the components of FIGS. 30A and 30B, and a partially enlarged view thereof;
FIG. 39 is an exploded perspective view of FIG. 38;
FIG. 40 is a perspective view illustrating a coupled state of the heat dissipation unit to the LED unit;
FIG. 41 is a cutaway perspective view of FIG. 40;
FIG. 42A is a perspective view illustrating a single heat dissipation unit among the components of FIG. 38;
FIG. 42B is an exploded perspective view of FIG. 42A;
FIG. 43 is a side view (a) of FIG. 42A, a cross-sectional view (b) taken along line C-C, and a partially enlarged view (c) thereof;
FIG. 44 is a side view (a) of FIG. 42A, a cutaway perspective view (b) taken along line C-C, and a partially enlarged view (c) thereof;
FIG. 45 is an internal perspective view (side view) illustrating a heat dissipation unit according to a fourth implementation among the components of FIGS. 25A and 25B; and
FIG. 46 is an exploded perspective view of FIG. 45.

### <Description of reference numerals>

100, 1000: Lighting apparatus 110: Lighting body
120: Light-transmitting panel 130: Press-fit portion
150: LED unit 200: Heat dissipation unit according to first implementation
210: First refrigerant flow path 220: Second refrigerant flow path
230: Third refrigerant flow path 240: Plurality of strength reinforcing portions
300: Absorber 301: Auxiliary absorber
500: Finger guard panel assembly 600: Angle adjustment unit
610: Fixing bracket 620: Steering block
630: Tilting block 1100: Lighting body
1111: Bracket frame portion 1150: LED unit
1151: LED board mounting block 1152: LED board
1155: LED element 1200, 1200', 1200": Heat dissipation unit
1200-1: One-side heat conduction panel 1200-2: Other-side heat conduction panel
1205: Refrigerant flow space 1210: First refrigerant flow path
1215: Inclined guide 1215a: Refrigerant dispersion guide
1220: Second refrigerant flow path 1230: Third refrigerant flow path
1240: Strength reinforcing portion 1300: Absorber
1310: Evaporation-portion sintered body 1320: Sintered-body column
1330: Sintered-body base 1500: Finger guard panel assembly
1600: Tilting bracket portion 1700: Electronic-component storage frame
1800: Blower unit

### [Mode for Invention]

Hereinafter, a lighting apparatus according to embodiments of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

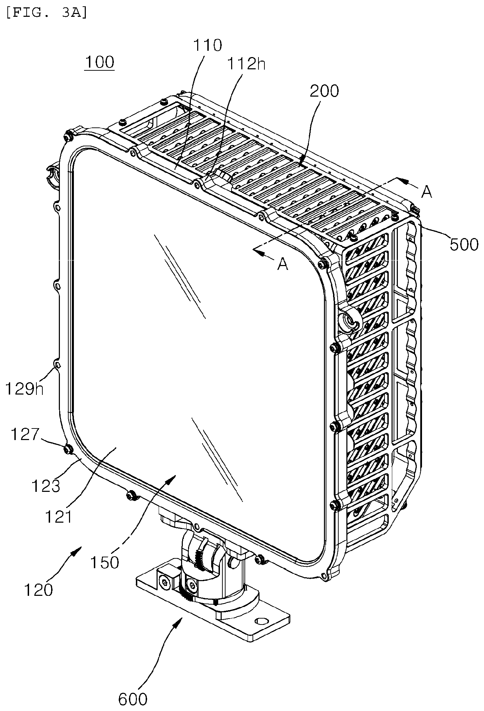

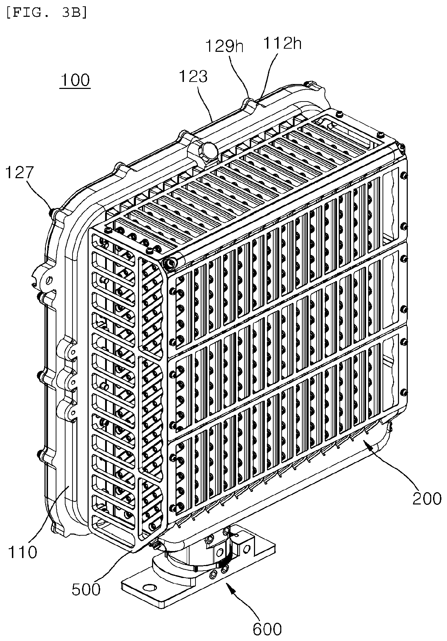

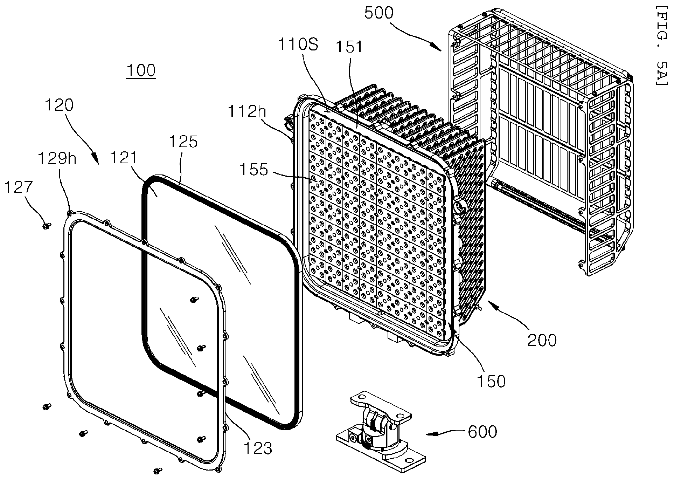

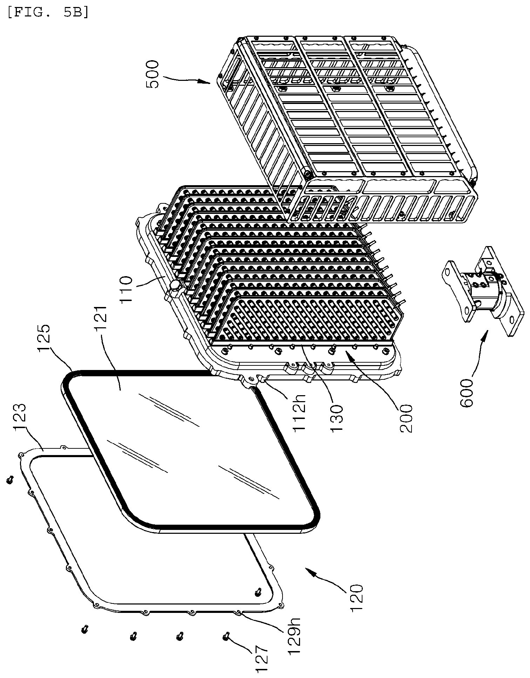

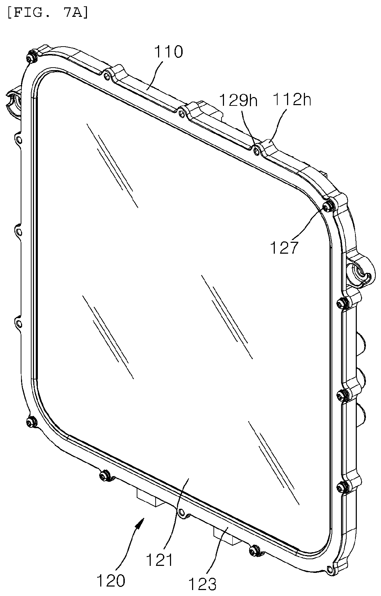

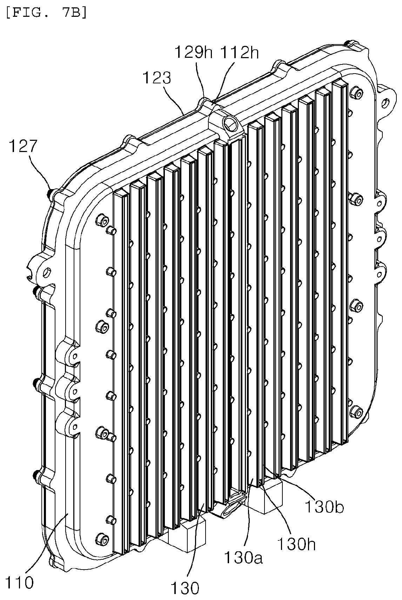

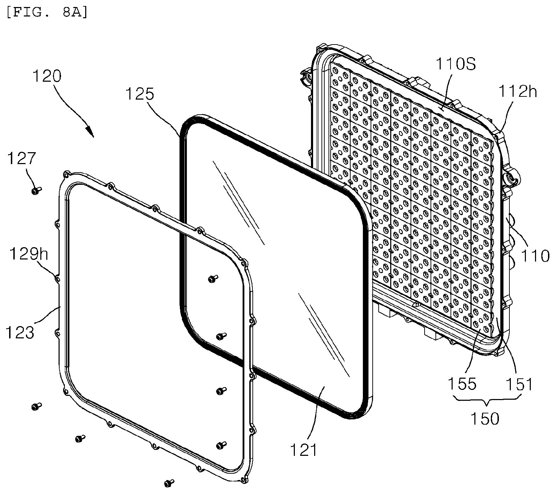

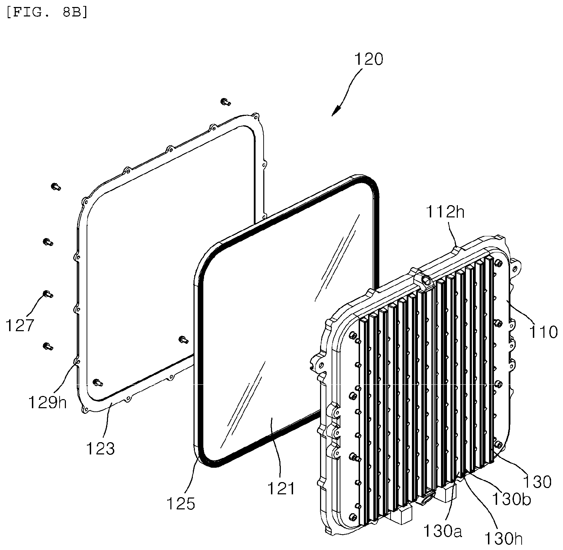

FIGS. 3A and 3B are front and rear perspective views illustrating a lighting apparatus according to an embodiment of the present disclosure, FIGS. 4A and 4B are exploded perspective views of FIGS. 3A and 3B, respectively, illustrating a state in which a heat dissipation unit is separated from a lighting body, FIGS. 5A and 5B are exploded perspective views of FIGS. 3A and 3B, respectively, illustrating a state in which a heat dissipation unit according to a first implementation is coupled to the lighting body, FIG. 6 is a cross-sectional view taken along line A-A of FIG. 3A, FIGS. 7A and 7B are front and rear perspective views illustrating the lighting body among components of FIGS. 3A and 3B, and FIGS. 8A and 8B are exploded perspective views of FIGS. 7A and 7B, respectively.

As illustrated in FIGS. 3A to 8B, a lighting apparatus 100 according to an embodiment of the present disclosure includes a lighting body 110 having a substantially rectangular (or square) vertical cross-sectional shape, a reduced thickness in a front-rear direction, and an open front surface, and an LED unit 150 seated and coupled inside the lighting body 110 and including an LED board 151 on which a plurality of LED elements 155 are mounted.

Here, the LED unit 150 may include a plurality of LED elements 155 mounted on one surface of both surfaces to form a light-emitting surface from which light is radiated, and the other surface of both surfaces may form a heat-generating surface that releases a predetermined amount of heat generated during operation of the LED elements 155.

The lighting body 110 may provide installation spaces for the LED unit 150 and a plurality of heat dissipation units 200, and may be formed such that a portion in a direction of the light-emitting surface of light generated from the LED unit 150 is open. The same may be applied to a lighting apparatus 1000 according to another embodiment of the present disclosure that will be described later.

An installation space 110S for stacking installation of the above-described LED unit 150 may be provided at a front portion of the lighting body 110 in the form of a groove having an opened front side, and a plurality of press-fit portions 130 for press-fitting installation of the heat dissipation unit 200 according to a first implementation to be described later may be integrally formed at a rear portion of the lighting body 110.

Thus, the plurality of heat dissipation units 200 may receive heat from the LED unit 150 via the lighting body 110 in which the plurality of press-fit portions 130 are formed to extend lengthwise in a vertical direction at a position corresponding to the heat-generating surface of the LED unit 150.

In addition, a plurality of screw fastening holes 112h for screw assembly of a light-transmitting panel 120 to be described later may be formed at spaced intervals along a front edge of the lighting body 110.

Meanwhile, the lighting apparatus 100 according to an embodiment of the present disclosure, as illustrated in FIGS. 6A to 8B, may further include the light-transmitting panel 120 made of a transparent material (or a translucent material) that transmits forward the light generated from the LED unit 150 densely mounted on a front surface of the LED board 151, the light-transmitting panel covering the open front surface of the lighting body 110.

More specifically, as illustrated in FIGS. 8A and 8B, the light-transmitting panel 120 may include a light-transmitting glass 121 provided in the form of a panel made of a transparent material (or a translucent material), a fixing frame 123 that mediates screw assembly of the light-transmitting glass 121 to a front end of the lighting body 110 using a plurality of fixing screws 127, and a waterproof gasket 125 interposed between the fixing frame 123 and an edge of the front end of the lighting body 110 to perform a waterproof function.

A plurality of screw through-holes 129h may be formed along a peripheral edge of the fixing frame 123 at positions respectively corresponding to the plurality of screw fastening holes 112h formed at the front end of the lighting body 110 so that the above-described fixing screws 127 pass therethrough.

Here, the waterproof gasket 125 may be made of a rubber material. When the fixing frame 123 is screw-fastened to the front end of the lighting body 110 using the fixing screws 127, fastening force of the fixing screws 127 is applied to the fixing frame 123, thereby compressively deforming the waterproof gasket to prevent foreign substances, including rainwater, from entering the interior.

Meanwhile, as described above, the plurality of press-fit portions 130 may be integrally formed on a rear portion of the lighting body 110.

The plurality of press-fit portions 130 are portions at which a plurality of heat dissipation units 200 to be described later are detachably installed, and may be provided in the form of a pair of slot ribs 130a and 130b having front ends protruding rearward by a predetermined length from a rear portion of the lighting body 110. The heat dissipation unit 200 may be press-fitted in an interference-fit manner into an installation groove 130h formed between the pair of slot ribs 130a and 130b such that a part thereof (e.g., a part of a refrigerant flow space 205 to be described later) is positioned therein.

Heat dissipation units 200, 1200, 1200', and 1200" provided in various implementations to be described later correspond to core heat dissipation means of electronic devices which, like the lighting apparatus 100 according to an embodiment of the present disclosure, generate a large amount of heat during operation and whose lifespan is determined depending on whether the heat is rapidly dissipated to the outside. The most important design factor is to design the heat dissipation units so that no temperature deviation occurs among the LED elements 155 constituting the LED unit 150.

In particular, in the case of spot lighting such as the lighting apparatus 100 according to an embodiment of the present disclosure, which is provided to emit a narrow beam, small-sized light sources (LED elements 155) are densely mounted, and a layout design of the heat dissipation units 200 for minimizing temperature deviation thereof is more urgently required.

More specifically, although spot lighting may generally obtain a desired light distribution effect as the size of the light source becomes smaller, a smaller light source size is highly disadvantageous in terms of heat dissipation.

Further, in spot lighting based on the LED unit 150 on which the plurality of LED elements 155 are mounted (i.e., the lighting apparatus 100 according to an embodiment of the present disclosure), in order to secure desired light distribution performance, the absolute temperature of the LED elements 155 should be low, and there should be no temperature deviation (relative temperature difference) among the LED elements 155. This is because, when the temperature deviation among the LED elements 155 is large, the lifespan of the lighting apparatus 100 is reduced and the light distribution performance deteriorates.

Therefore, in the design of the heat dissipation unit employed in conventional spot lighting, it has been required to derive an optimal design according to the outer shape of the lighting body or the position of the LED unit disposed therein in order to minimize the above-described temperature deviation. Inevitably, additional heat dissipation components have been required, thereby increasing the number of parts and causing an enlargement of the product size.

The lighting apparatus 100 according to an embodiment of the present disclosure, as illustrated in FIGS. 3A to 8B, may further include the plurality of heat dissipation units 200 implemented according to the first implementation, which are press-fitted into the press-fit portions 130 formed on the rear portion of the lighting body 110, so that no temperature deviation occurs among the LED elements 155 even when employed as a type of spot lighting, without requiring a separate detailed heat dissipation design.

In addition, an angle adjustment unit 600 may be coupled to a lower side of the lighting body 110 to adjust an irradiation angle with respect to a lighting direction of the lighting body 110. A detailed configuration and function of the angle adjustment unit 600 will be described in greater detail later.

Meanwhile, a finger guard panel assembly 500 according to an implementation, which is provided to cover all portions of the plurality of heat dissipation units 200 except for lower ends thereof and is provided with a plurality of ventilation holes (not shown) in a grill form to allow outside air (outdoor air) to pass therethrough for heat exchange with the heat dissipation units 200, may be further coupled to the rear portion of the lighting body 110.

As illustrated in FIGS. 4A and 4B, the finger guard panel assembly 500 may include a left finger guard panel 500L covering a left side of the plurality of heat dissipation units 200, a right finger guard panel 500R covering a right side of the plurality of heat dissipation units 200, an upper finger guard panel 500T covering upper portions of the left finger guard panel 500L and the right finger guard panel 500R, a rear finger guard panel 500P connected to rear ends of the left finger guard panel 500L and the right finger guard panel 500R and covering rear portions of the plurality of heat dissipation units 200, and the upper finger guard panel 500T covering upper ends of the plurality of heat dissipation units 200.

In addition, the finger guard panel assembly 500 may further include a lower horizontal panel bar 500DB connected to and supporting lower ends of the left finger guard panel 500L, the right finger guard panel 500R, and the rear finger guard panel 500P, and an upper horizontal panel bar 500UB connected to and supporting upper ends of the left finger guard panel 500L, the right finger guard panel 500R, and the rear finger guard panel 500P.

Here, each of the finger guard panels 500L, 500R, 500P, and 500T may have mutually contacting ends screw-fastened using a plurality of fixing screws 503, or may have mutually contacting ends screw-fastened using a plurality of fixing screws (not shown) via the lower horizontal support bar 500DB or the upper horizontal support bar 500UB.

Meanwhile, as illustrated in FIG. 6, a seating groove 505 inclined downward from a front portion toward a rear portion is formed in the lower horizontal support bar 500DB, and an air vent tube 270 among the components of the heat dissipation unit 200 to be described later may be accommodated in the seating groove 505 so as to be protected from the outside.

Each of the finger guard panels 500L, 500R, 500P, and 500T of the finger guard panel assembly 500 according to an implementation may be provided in the form of a panel having a plurality of ventilation holes 501 of a size that facilitates inflow of outdoor air and outflow of indoor air with respect to the heat dissipation unit 200 to be protected therein, while preventing access of skin, including a finger of an external worker.

However, the respective finger guard panels 500L, 500R, 500P, and 500T, which are main components of the finger guard panel assembly 500, are not necessarily provided in the panel form, and some components may be replaced with a configuration such as a support pipe 510 within a range that maintains a frame structure, as in a finger guard panel assembly 500-1 according to another implementation to be described later. This will be described in greater detail later.

Here, among the components of the finger guard panel assembly 500, front ends of the left finger guard panel 500L and the right finger guard panel 500R may be screw-fastened and fixed to left and right peripheral edges of the rear portion of the lighting body 110, respectively. In a state in which left and right ends of the upper horizontal panel bar 500UB and the lower horizontal panel bar 500DB are coupled in a left-right horizontal direction to upper and lower portions of rear ends of the right finger guard panel 500R and the left finger guard panel 500L, respectively, the upper finger guard panel 500T may be screw-fastened and fixed to upper and lower portions of the right finger guard panel 500R and the left finger guard panel 500L, respectively. Further, the rear finger guard panel 500P may be screw-fastened and fixed to the rear ends of the right finger guard panel 500R and the left finger guard panel 500L and to the upper horizontal panel bar 500UB and the lower horizontal panel bar 500DB.

In particular, the lower horizontal panel bar 500DB may be further formed with heat-dissipation-plate support slits 500DB-1 provided in a slit form so as to respectively support portions corresponding to heat dissipation plate portions 203 among the components of the heat dissipation unit 200 according to the first implementation to be described later.

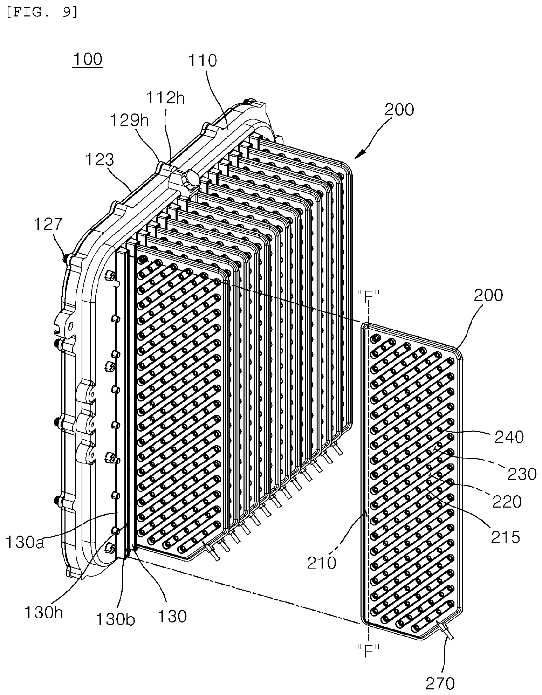

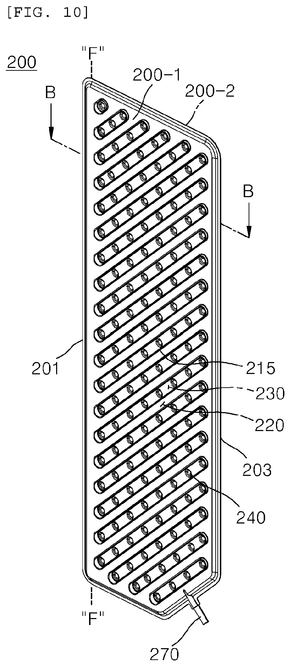

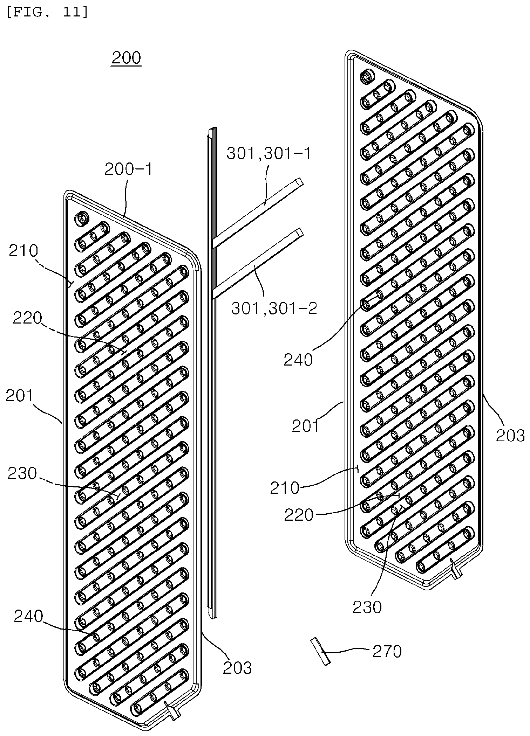

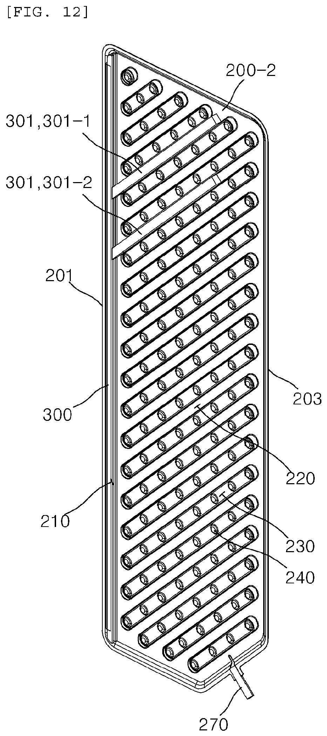

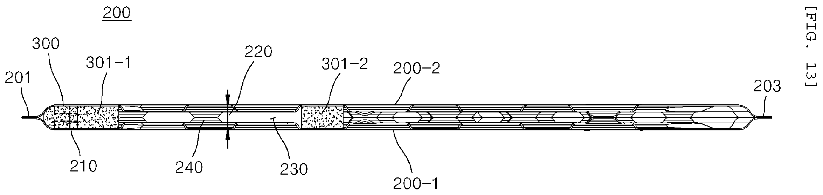

FIG. 9 is an exploded perspective view illustrating a state in which the heat dissipation unit according to the first implementation is installed on a rear portion of the lighting body, FIG. 10 is a perspective view illustrating the heat dissipation unit according to the first implementation for dissipating heat of the lighting apparatus according to an embodiment of the present disclosure, FIG. 11 is an exploded perspective view of FIG. 10, FIG. 12 is a perspective view illustrating a state in which a one-side heat conduction panel among components of the heat dissipation unit of FIG. 10 is removed, and FIG. 13 is a cross-sectional view taken along line B-B of FIG. 10.

The heat dissipation unit 200 according to the first implementation, as illustrated in FIG. 9, may be arranged to extend lengthwise in a vertical (up-and-down) direction on a rear portion of the lighting body 110, and a plurality of heat dissipation units may be arranged in a left-right direction of the lighting body 110 so as to be spaced apart from one another by a predetermined distance.

Here, the heat dissipation units 200 according to the first implementation are provided in plurality, each being disposed vertically in a gravitational direction with respect to the heat-generating surface of the LED unit 150 and spaced apart from one another by a predetermined distance in the left-right direction, and a refrigerant flow space 205 filled with a phase-changeable refrigerant may be formed therein.

For installation of the plurality of heat dissipation units 200, the press-fit portions 130 provided at the rear portion of the lighting body 110 may also be arranged to extend lengthwise in a vertical (up-and-down) direction, and the respective press-fit portions 130 may be arranged in parallel with one another while being spaced apart by a predetermined distance in a left-right direction.

According to the press-fit portions 130 configured as described above, an upward airflow generated by the heat dissipation units 200 at the rear portion of the lighting body 110 has an advantage in heat dissipation design by minimizing flow resistance in a directly upward direction.

The heat dissipation unit 200 according to the first implementation may form a refrigerant flow space 205 filled with the refrigerant therein, as illustrated in FIGS. 9 to 13.

More specifically, as illustrated in FIGS. 10 to 13, the heat dissipation unit 200 according to the first implementation may include a one-side heat conduction panel 200-1 forming one side surface in a thickness direction of the refrigerant flow space 205 and an other-side heat conduction panel 200-2 forming the other side surface in the thickness direction of the refrigerant flow space 205.

Here, the refrigerant flow space 205 may be formed by bonding the one-side heat conduction panel 200-1 and the other-side heat conduction panel 200-2, formed of two metal panel members, along peripheral edges thereof, or by bending a single metal panel member and then bonding peripheral edges thereof except for bent portions of the one-side heat conduction panel 200-1 and the other-side heat conduction panel 200-2 that are mutually joined.

Meanwhile, as illustrated in FIGS. 10 to 13, the refrigerant flow space 205 may include a first refrigerant flow path 210 corresponding to an evaporation region in which liquid refrigerant of the refrigerant is stored (retained) and the stored (retained) liquid refrigerant undergoes a phase change (evaporation) into a gas state by heat supplied from the LED unit 150, the first refrigerant flow path being formed to extend lengthwise in a vertical direction, and a second refrigerant flow path 220 that is a flow path of liquid refrigerant and is formed in a condensation region other than the evaporation region. One end of the second refrigerant flow path may communicate with the first refrigerant flow path 210, and the other end thereof may be inclined in a rearward oblique direction to be positioned higher in a gravitational direction than the one end, thereby guiding liquid refrigerant that has been phase-changed by condensation from a gas state in the condensation region to flow toward the first refrigerant flow path 210.

Hereinafter, a region which is positioned close to the LED unit 150 and in which liquid refrigerant undergoes a phase change into gas refrigerant by heat supplied from the LED unit 150 may be defined as the above-described "evaporation region," and an entire portion of the refrigerant flow space 205 excluding the evaporation region may be defined as the above-described "condensation region," in which gas refrigerant undergoes a phase change into liquid refrigerant. The first refrigerant flow path 210 may be located in a portion corresponding to the evaporation region, and the second refrigerant flow path 220 may be located in a portion corresponding to the condensation region.

Here, although the evaporation region and the condensation region are classified according to the function of the refrigerant, they are not completely physically separated. Based on reference numeral "F" in FIG. 10, a front end on the side of a press-fit end 201, which will be described later, of the heat dissipation unit 200 according to the first implementation, which is a portion press-fitted into the press-fit portion 130 of the lighting body 110, may be defined as the evaporation region, and the remaining portion may be defined as the condensation region.

Further, one end at which the first refrigerant flow path 210 is located as the evaporation region may be defined as the "press-fit end 201" in that it is installed in the press-fit portion 130 provided at the rear portion of the lighting body 110 described above, and peripheral edges other than the press-fit end 201 may be defined as a "heat dissipation plate portion 203" in that they perform heat dissipation through substantial heat exchange with outdoor air.

In particular, the first refrigerant flow path 210 may be a position in which liquid refrigerant of the refrigerant is filled, with only a separation distance corresponding to a material thickness of the metal panel member interposed between the first refrigerant flow path and the press-fit portion 130 adjacent to the LED unit 150.

In this case, the first refrigerant flow path 210 may be a portion in which liquid refrigerant of the refrigerant filled in the refrigerant flow space 205 is stored and retained, and may be arranged vertically in a gravitational direction. Therefore, the liquid refrigerant stored in the first refrigerant flow path 210 may have a liquid level positioned relatively lower in the gravitational direction in consideration of an increase in volume when it undergoes a phase change into gas refrigerant.

In addition, the "separation distance corresponding to the material thickness" may refer to a distance by which the first refrigerant flow path 210 is spaced apart from the LED unit 150 or the press-fit portion 130.

Meanwhile, the second refrigerant flow path 220 may have its shape defined by a plurality of inclined guides 215 protruding toward the refrigerant flow space 205 to substantially prevent directly dropping of the condensed liquid refrigerant in a gravitational direction and to guide an inclined flow toward the first refrigerant flow path 210 by a property of surface tension of the liquid.

More specifically, when the refrigerant in a gas state (gas refrigerant) is aggregated into a refrigerant in a liquid state (liquid refrigerant) through a heat exchange process with outdoor air in the condensation region, the second refrigerant flow path 220 provides a flow path such that, as the volume gradually increases at a position in the refrigerant flow space 205 where aggregation occurs and the liquid flows downward in the gravitational direction, a uniform amount of liquid refrigerant flows toward and is supplied to the first refrigerant flow path 210.

In particular, as will be described later, the second refrigerant flow path 220 may be defined between the plurality of inclined guides 215. When the liquid refrigerant aggregated in the condensation region flows down toward the first refrigerant flow path 210, dispersed flow toward a second refrigerant flow path 220 adjacent to its own flow path, that is, the second refrigerant flow path 220 may be suppressed by surface tension.

That is, since flow spaces defined by the plurality of inclined guides 215 are narrower than the second refrigerant flow path 220, as will be described later, surface tension acts so that flow toward adjacent second refrigerant flow paths 220 is restrained.

As described above, when dispersed flow of the condensed liquid refrigerant is restrained by the plurality of inclined guides 215 and the second refrigerant flow paths 220, direct downward dropping of the liquid refrigerant in a gravitational direction may be minimized. Further, by lower ends respectively connected to the first refrigerant flow path 210 at uniform intervals, the liquid refrigerant aggregated in the condensation region may be supplied in a uniform amount toward the first refrigerant flow path 210 without being concentrated in a particular region.

In addition, the plurality of second refrigerant flow paths 220 may be defined between the plurality of inclined guides 215 protruding inward into the refrigerant flow space 205 from mutually facing surfaces of the one-side heat conduction panel 200-1 and the other-side heat conduction panel 200-2.

Here, the plurality of inclined guides 215 defining the second refrigerant flow paths 220 may be provided in a form protruding toward the refrigerant flow space 205 from respective inner surfaces of the one-side heat conduction panel 200-1 and the other-side heat conduction panel 200-2, as illustrated in FIGS. 10 and 13.

The plurality of inclined guides 215 may be provided in a straight-line form inclined downward in a gravitational direction toward the first refrigerant flow path 210. Thus, the liquid refrigerant condensed at the heat dissipation plate portion 203 side may naturally aggregate and then flow down toward the first refrigerant flow path 210 along spaces between the plurality of downwardly inclined guides 215, thereby serving to enhance a circulation speed of the liquid refrigerant.

Here, the plurality of second refrigerant flow paths 220 or the plurality of inclined guides 215 may be arranged such that adjacent second refrigerant flow paths 220 or inclined guides 215 are disposed parallel to one another. In general, liquid refrigerant condensed in a wide condensation region having a larger area than the evaporation region limited to the first refrigerant flow path 210 may have its flow distributed through the second refrigerant flow paths 220 or the inclined guides 215, which are densely and uniformly arranged in parallel, thereby providing an advantage in that heat is dissipated through the entire condensation region (or the heat dissipation plate portion 203) with uniform heat dissipation performance.

Further, the plurality of inclined guides 215 may be formed on each of the one-side heat conduction panel 200-1 and the other-side heat conduction panel 200-2, and tip portions thereof protruding toward the refrigerant flow space 205 may be formed so as not to be joined within the refrigerant flow space 205 but to be spaced apart from each other.

As described above, since the second refrigerant flow path 220 performs a function of guiding the flow of liquid refrigerant in a gravitational direction, it is preferable that the second refrigerant flow path 220 have a thickness-direction dimension that allows the flow to be naturally formed in the gravitational direction without being stopped by surface tension, which is an inherent property of liquid. In addition, the second refrigerant flow path 220 may be formed such that, after the liquid refrigerant aggregates to at least a predetermined size, dispersed flow toward an adjacent second refrigerant flow path 220 by surface tension or gravity is restrained.

Further, in the plurality of second refrigerant flow paths 220 or the plurality of inclined guides 215, at least one of opposite ends thereof may be connected to the evaporation region or to the first refrigerant flow path 210 formed in the evaporation region, and an end (i.e., one of the opposite ends) connected to the evaporation region or to the first refrigerant flow path 210 formed therein may be positioned lower in a gravitational direction than the other end.

Thus, when at least one of opposite ends of the plurality of second refrigerant flow paths 220 is defined as "one end," the one end may have the same meaning as a "lower end" positioned lower in a gravitational direction. Conversely, when the other of the opposite ends of the plurality of second refrigerant flow paths 220 is defined as "the other end," the other end may have the same meaning as an "upper end" positioned higher in the gravitational direction.

Furthermore, as described above, in the plurality of second refrigerant flow paths 220 or the plurality of inclined guides 215, at least one of the opposite ends may be connected to the first refrigerant flow path 210, and the opposite ends may be formed to be aligned in a straight line.

Such a straight-line configuration of the plurality of second refrigerant flow paths 220 may minimize a distance between one end at a side of the first refrigerant flow path 210, which is positioned closest to the heat-generating elements 140 and receives heat therefrom, and the other end at an outermost edge of the condensation region where condensation actively occurs through heat exchange with outside air, and the straight-line configuration of the second refrigerant flow paths 220 themselves may be recognized as an optimal shape capable of minimizing an overlapping length (flow resistance length) between a flow path of the liquid refrigerant and a flow path of the gas refrigerant.

That is, in the heat dissipation unit 200, the first refrigerant flow path 210 at a portion corresponding to the press-fit end 201 of the refrigerant flow space 205 formed inside the one-side heat conduction panel 200-1 and the other-side heat conduction panel 200-2 is positioned close to the LED unit 150 or the press-fit portion 130, and a straight-line structure and a gas-liquid flow separation structure are applied such that gas-liquid circulation from the first refrigerant flow path 210 (i.e., one end in the width direction) to an outer end of the condensation region (i.e., the other end in the width direction) is smoothly performed without substantial flow resistance.

Further, the second refrigerant flow paths 220 are formed such that a plurality thereof do not branch from the other end in the width direction toward the one end in the width direction, which corresponds to the first refrigerant flow path 210 positioned relatively lower in the gravitational direction, in order to guide liquid flow of the liquid refrigerant that has undergone the phase change from the gas refrigerant within the refrigerant flow space.

Meanwhile, as described above, the plurality of inclined guides 215 not only define the second refrigerant flow paths 220 between the respective inclined guides 215 as flow paths that guide the flow of liquid refrigerant in the gravitational direction, but may also perform a function of defining a third refrigerant flow path 230 to be described later, corresponding to a spaced portion in the thickness direction.

In this case, on the premise that the first refrigerant flow path 210 is positioned relatively lower in the gravitational direction due to tilting adjustment of the entire lighting body 110, it is preferable that the plurality of inclined guides 215 be patterned to be inclined with respect to the first refrigerant flow path 210 so as to form a flow path along which liquid refrigerant flows.

Here, the second refrigerant flow paths 220 defined as spaces between adjacent inclined guides 215 may be refrigerant flow paths extending upwardly and obliquely from the first refrigerant flow path 210 toward width-direction ends of the one-side heat conduction panel 200-1 and the other-side heat conduction panel 200-2, respectively. This is intended to allow the liquid refrigerant liquefied at the heat dissipation plate portion 203 side to be easily moved by its own weight toward the first refrigerant flow path 210 provided with the absorber 300.

Meanwhile, at portions corresponding to the condensation region of the one-side heat conduction panel 200-1 and the other-side heat conduction panel 200-2, a plurality of strength reinforcing portions 240 may be symmetrically formed to protrude into the refrigerant flow space 205.

When the one-side heat conduction panel 200-1 and the other-side heat conduction panel 200-2 are mutually joined by a bending or joining method, the plurality of strength reinforcing portions 240 may have their mutually contacting portions within the refrigerant flow space 205 joined through a joining process using various coupling methods, including a laser welding method, thereby serving to reinforce the overall strength of the heat dissipation unit 200.

In addition, the plurality of strength reinforcing portions 240 may also serve to promote active condensation by providing a larger interference area against which the gas refrigerant, vaporized for heat dissipation in the condensation region, impinges. That is, the plurality of strength reinforcing portions 240 further increase the contact surface area with the gas refrigerant flowing freely through the third refrigerant flow path 230, which will be described later, thereby enabling the refrigerant to condense within a shorter period of time.

In addition, the heat dissipation unit 200 according to the first embodiment may further include the third refrigerant flow path 230, which serves as a flow path for the gas refrigerant other than the liquid refrigerant mainly flowing along the plurality of inclined guides 215, as described with reference to FIGS. 10 to 13.

Referring to FIG. 13, the second refrigerant flow path 220 is formed in each of the one-side heat conduction panel 200-1 and the other-side heat conduction panel 200-2, and is defined as being formed between adjacent ones of the plurality of inclined guides 215, excluding the thickness direction of the refrigerant flow space 205. In contrast, the third refrigerant flow path 230 may be defined, in the thickness direction of the refrigerant flow space 205, as a space between the inclined guide 215 formed on the one-side heat conduction panel 200-1 and the inclined guide 215 formed on the other-side heat conduction panel 200-2.

However, when defining the second refrigerant flow path 220, the expression "excluding the thickness direction" means that the reference direction for the definition is not the thickness direction, and it should not be construed as excluding the volume occupied by the thickness direction as a corresponding volume or space.

More specifically, the third refrigerant flow path 230 may be defined in a case where the inclined guides 215 protrude further into the refrigerant flow space 205 than the second refrigerant flow path 220, such that a thickness dimension of the refrigerant flow space 205 is set to be smaller than that of the second refrigerant flow path 220. That is, the third refrigerant flow path 230 may be defined as a region having a smaller thickness than the second refrigerant flow path 220, as defined by the plurality of inclined guides 215.

In addition, the third refrigerant flow path 230 may be defined as a portion, among opposing surfaces of the one-side heat conduction panel 200-1 and the other-side heat conduction panel 200-2 of the heat conduction panel bodies 200-1 and 200-2, where the plurality of inclined guides 215 are formed and which is not joined within the refrigerant flow space 205 but remains spaced apart from each other.

The third refrigerant flow path 230 may serve to provide a gas flow path to allow the refrigerant filled in the refrigerant flow space 205, after undergoing the phase change into the gas refrigerant in the evaporation region which is the first refrigerant flow path 210, to be easily diffused and flow throughout the entire heat dissipation plate portion 203. The gas refrigerant evaporated in the first refrigerant flow path 210, which is the evaporation region, may move toward the heat dissipation plate portion 203 and be smoothly and uniformly dispersed through the third refrigerant flow path 230 to perform heat dissipation while being condensed.

For example, when the liquid refrigerant naturally flows downward through the space between adjacent inclined guides 215 adjacent to the second refrigerant flow path 220, the gas refrigerant actively flows through the third refrigerant flow path 230, which is a space not occupied by the liquid refrigerant.

However, this does not mean that the liquid refrigerant is completely separated from the gas refrigerant and does not occupy the third refrigerant flow path 230. Rather, it is preferable to understand that the gas refrigerant flows more actively through the third refrigerant flow path 230.

That is, since the phase change of the refrigerant does not occur with the liquid refrigerant and the gas refrigerant being completely separated, it is difficult to define them with precise distinction. However, in general, the second refrigerant flow path 220, having a relatively larger dimension in the thickness direction, may serve as a path through which the liquid refrigerant mainly flows, while the third refrigerant flow path 230 may serve as a path through which the gas refrigerant mainly flows.

More specifically, because the gas refrigerant is more active than the liquid refrigerant, the third refrigerant flow path 230, having a relatively smaller dimension in the thickness direction, may serve as the main flow path for the gas refrigerant. In contrast, considering the surface tension of the liquid refrigerant itself, the second refrigerant flow path 220, having a larger dimension in the thickness direction than the third refrigerant flow path 230, may serve as the main flow path for the liquid refrigerant.

Meanwhile, the third refrigerant flow path 230 may also be defined as a refrigerant flow path that connects spaces between the second refrigerant flow paths 220, which are spaced apart from each other in parallel.

For example, each of the second refrigerant flow paths 220 may have a predetermined pattern shape, the second refrigerant flow path being processed to protrude from portions of the one-side heat conduction panel 200-1 and the other-side heat conduction panel 200-2 where the refrigerant flow space 205 is formed, and being partitioned by the third refrigerant flow path 230, which is formed so as not to be in surface contact within the refrigerant flow space 205. It should be noted that the term "partitioned" as used herein does not mean a physically and spatially complete partition, but rather refers to a distinction in shape and position between the second refrigerant flow path 220 and the third refrigerant flow path 230.

In the lighting apparatus 100 according to an embodiment of the present disclosure having the above-described configuration, the heat dissipation unit 200 according to the first implementation is configured such that the liquid refrigerant condensed in the condensation region other than the evaporation region flows downward in the direction of gravity along the plurality of inclined guides 215 defining the second refrigerant flow path 220, and the gas refrigerant evaporated in the evaporation region flows in a gas state between the plurality of inclined guides 215 defining the third refrigerant flow path 230.

Meanwhile, in the evaporation region corresponding to the first refrigerant flow path 210, an absorber 300 may be further installed to absorb the liquid refrigerant and to promote active vaporization of the absorbed liquid refrigerant by heat supplied from the LED unit 150.

That is, the absorber 300 may be disposed on the first refrigerant flow path 210 positioned close to the LED unit 150 or the press-fit portion 130, which is a heat dissipation target, and may serve to raise at least the liquid refrigerant of the refrigerant upward beyond its absorption point by capillary force or absorption force.

To this end, the absorber 300 may be made of a fibrous material such as a nonwoven fabric having a plurality of pores formed therein. In addition, since it is disposed on the first refrigerant flow path 210 extending vertically, it is preferably formed of a material capable of dispersing and transporting the liquid refrigerant by capillary action (or inherent absorption force) against gravity (i.e., in a direction opposite to gravity) over at least a predetermined height in the vertical direction.

More specifically, the absorber 300 may include any one of a nonwoven fabric forming a plurality of pores (a kind of wick structure), a nonwoven fabric supported by a metal wire or a metal braided body, and a metal sintered body formed by sintering metal powder.

The metal material here may include copper having excellent thermal conductivity, and the nonwoven fabric may be supported by a thin metal wire made of copper or by a copper wire braided body formed by braiding such metal wires.

That is, the absorber 300 may be adopted as a nonwoven fabric itself made of a fibrous material. In this case, since the nonwoven fabric is inherently very flexible and may have difficulty maintaining its shape in the vertical direction due to the weight of the absorbed liquid refrigerant when the liquid refrigerant is absorbed, the nonwoven fabric may be provided to be supported by a copper wire or by a braided body made of copper wire braided together.

Here, the nonwoven fabric may be configured to be inserted into the braided body made of copper wire so that its shape is maintained. Thus, the nonwoven fabric provided as the absorber 300 may be stably fixed and prevented from moving on the first refrigerant flow path 210 arranged in the direction of gravity (i.e., the vertical direction) or inclined with respect to the direction of gravity.

However, it is not necessarily required that the nonwoven fabric be supported by being inserted into the interior of the braided body made of copper wire. Rather, it is also possible to adopt a support configuration in which a single strand of copper wire penetrates the nonwoven fabric in the vertical direction, or in which the copper wire spirally surrounds the nonwoven fabric.

In addition, as long as the absorber 300 may maintain its shape despite the load of the retained liquid refrigerant, the nonwoven fabric may be coupled to the interior of the braided body made of copper wire. Alternatively, the copper wire itself or the braided body made of copper wire may be provided to spirally surround an outer circumferential surface of the nonwoven fabric.

Meanwhile, in the heat dissipation unit 200 according to the first implementation, when the first refrigerant flow path 210 is formed to be very long in the vertical direction, at least one auxiliary absorber 301 may be further provided in a portion of the second refrigerant flow path 220 at an upper side of the refrigerant flow space 205.

The auxiliary absorber 301 may be seated and installed in an auxiliary absorber installation portion (not shown in the drawings), which is formed by modifying and processing a part of the second refrigerant flow path 220 to have a relatively larger width.

As shown in FIG. 11, two auxiliary absorbers 301-1 and 301-2 of the auxiliary absorber 301 may be arranged to be vertically spaced apart from each other at a relatively upper side in the direction of gravity.

Meanwhile, as shown in FIGS. 9 to 12, the heat dissipation unit 200 may further include an air vent tube 270 at an end forming the heat dissipation plate portion 203, the air vent tube being configured to evacuate the refrigerant flow space 205 before or after the refrigerant is injected into the refrigerant flow space 205.

When the evacuation of the refrigerant flow space 205 described above is completed, the air vent tube 270 may be cut by a cutter (not shown) and then sealed through a predetermined caulking process. Alternatively, after completing the caulking process without cutting, the air vent tube 270 may be inserted into the seating groove 505 formed in the lower horizontal support bar 500DB among the components of the finger guard panel assembly 500 described above, thereby being protected from the outside.

In addition, the one-side heat conduction panel 200-1 and the other-side heat conduction panel 200-2 constituting the heat dissipation unit 200 according to the first implementation may be provided in the form of plates made of SUS (stainless steel) among metal panel members, as described above. Accordingly, unlike a case in which the metal panel member is made of aluminum, the refrigerant filled therein may be water.

This is because, when the metal panel member of the heat dissipation unit 200 according to the first implementation is made of aluminum, aluminum has a chemical property of being converted into aluminum oxide while generating hydrogen while it comes into contact with water, so that water is excluded from the types of refrigerants that may be employed.

The heat dissipation unit 200 made of aluminum is expected to exhibit much higher heat dissipation performance than one made of SUS in terms of the intrinsic thermal conductivity of the material itself. However, in the lighting apparatus 100 according to an embodiment of the present disclosure, the heat dissipation unit 200 is provided as a metal panel member made of SUS and employs a heat transfer method using a phase change material (in particular, water) that may be filled in the refrigerant flow space 205, thereby achieving a remarkable improvement in heat dissipation performance. Accordingly, unlike the conventional lighting apparatus (see the Background Art of the invention), there is no need for an additional heat dissipation structure to address concentrated heat generation at a central portion, and sufficient heat dissipation may be achieved solely by the heat dissipation unit 200 according to an embodiment of the present disclosure, which is vertically arranged in the up-down direction.

In the heat dissipation unit 200 according to the first implementation provided for heat dissipation of the lighting apparatus 100 according to an embodiment of the present disclosure, even when formed of SUS having a lower thermal conductivity than aluminum, water, which poses no risk of environmental contamination, may be adopted as the refrigerant filled therein. In addition, through the first refrigerant flow path 210 corresponding to the evaporation region and the plurality of second refrigerant flow paths 220 provided to supply a uniform amount of liquid refrigerant to the first refrigerant flow path 210, more active gas-liquid circulation is enabled, thereby significantly improving the heat dissipation performance. As a result, there is an advantage in that no separate heat dissipation design is required to prevent temperature deviation among the LED elements 155 densely mounted in a narrow area to perform the function of a spot lighting apparatus.

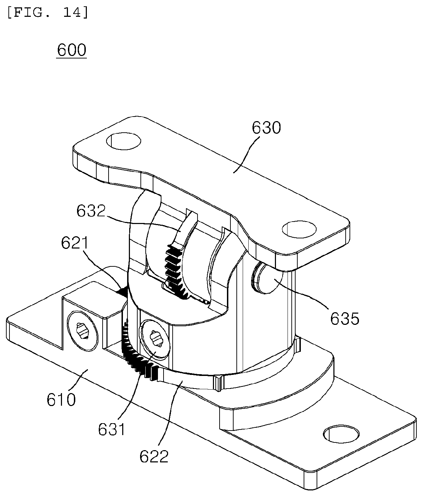

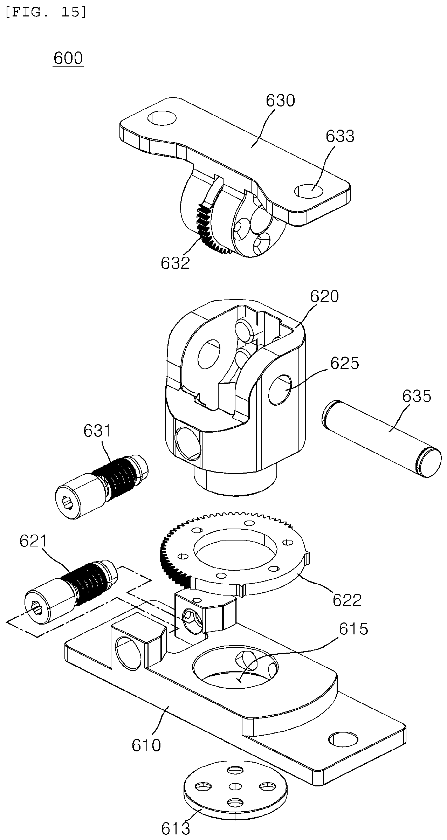

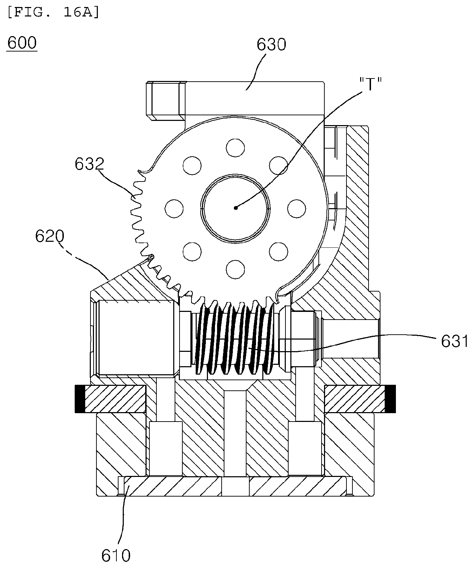

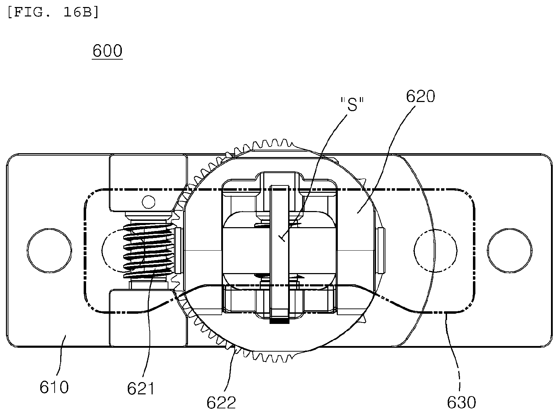

FIG. 14 is a perspective view illustrating the angle adjustment unit among the components of the lighting apparatus according to an embodiment of the present disclosure, FIG. 15 is an exploded perspective view of FIG. 14, and FIGS. 16A and 16B are partial perspective views for explaining an operation state by tilting rotation and steering rotation of the angle adjustment unit.

Referring to FIGS. 14 to 16B, the lighting apparatus 100 according to an embodiment of the present disclosure may further include the angle adjustment unit 600 disposed at a lower end of the lighting body 110 and configured to adjust an irradiation direction of the LED unit 150.

As shown in FIGS. 14 and 15, the angle adjustment unit 600 may include a fixing bracket 610 configured to fix the lighting body 110 at a predetermined position, a steering block 620 configured to steer and rotate left and right about a vertical axis S with respect to the fixing bracket 610, and a tilting block 630 configured to tilt and rotate forward and backward with respect to the steering block 620 about a horizontal left-right coupling shaft 635 or T, with a lower end of the lighting body 110 being connected thereto.

Here, the steering block 620 may be coupled to the fixing bracket 610 so as to be rotatable via a fixing panel 613 coupled to a lower portion of the fixing bracket 610 in a state in which a lower end of the steering block 620 is inserted into an installation hole 615 formed to vertically penetrate the fixing bracket 610.

The steering block 620 may be provided with a steering worm wheel gear 622 having a plurality of worm wheel gear teeth (no reference numeral assigned) formed on a portion of its outer circumferential surface. The fixing bracket 610 may be rotatably provided with a steering worm gear 621 having worm gear teeth (no reference numeral assigned) formed to engage with the worm wheel gear teeth of the steering worm wheel gear 622, such that the steering worm gear may engage with the steering worm wheel gear 622.

Here, the lighting body 110 is configured such that the steering block 620 is steered and rotated in the left-right direction according to the axial rotation of the steering worm gear 621, thereby allowing the irradiation direction of the LED unit 150 to be adjusted.

In addition, the steering block 620 may be formed with a left-right horizontal shaft coupling hole 625 penetrating therethrough in the left-right direction, and a lower end of the tilting block 630 may be tiltably coupled by the left-right horizontal coupling shaft 635 passing through the left-right horizontal shaft coupling hole 625.

Further, the steering block 620 may be rotatably provided with a tilting worm wheel gear 632 having a plurality of worm wheel gear teeth (no reference numeral assigned) formed on a portion of its outer circumferential surface. A tilting worm gear 631 having worm gear teeth (no reference numeral assigned) engageable with the worm wheel gear teeth of the tilting worm wheel gear 632 may be rotatably provided at the lower end of the tilting block 630.

Here, the lighting body 110 is configured such that the tilting block 630 is tilted and rotated in the forward and backward direction according to the axial rotation of the tilting worm gear 631, thereby allowing the irradiation direction of the LED unit 150 to be adjusted.

The tilting block 630 may be formed with a bolt fastening hole 633 for bolt connection with the lower end of the lighting body 110.

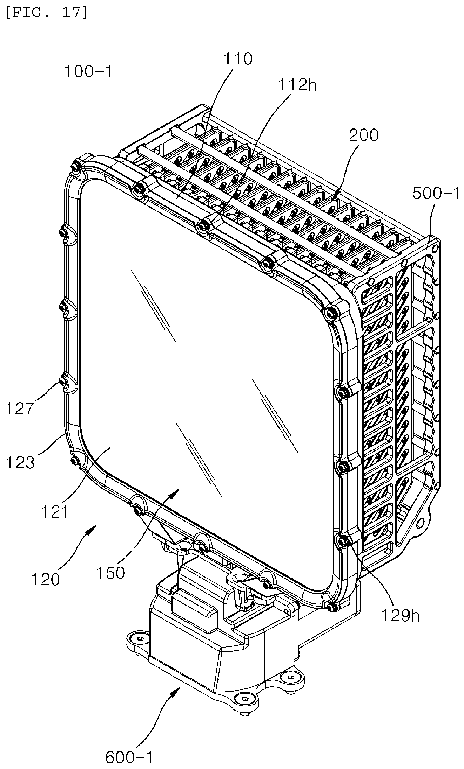

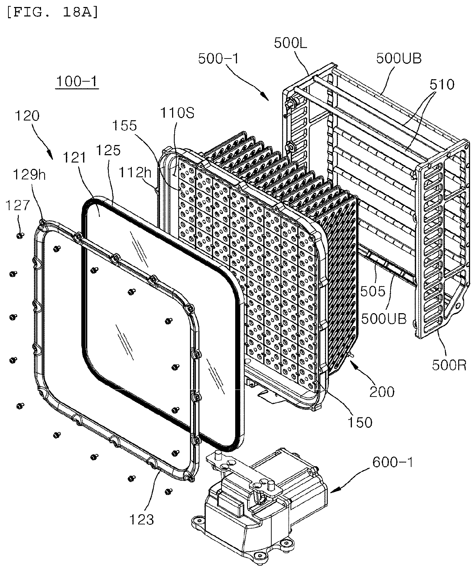

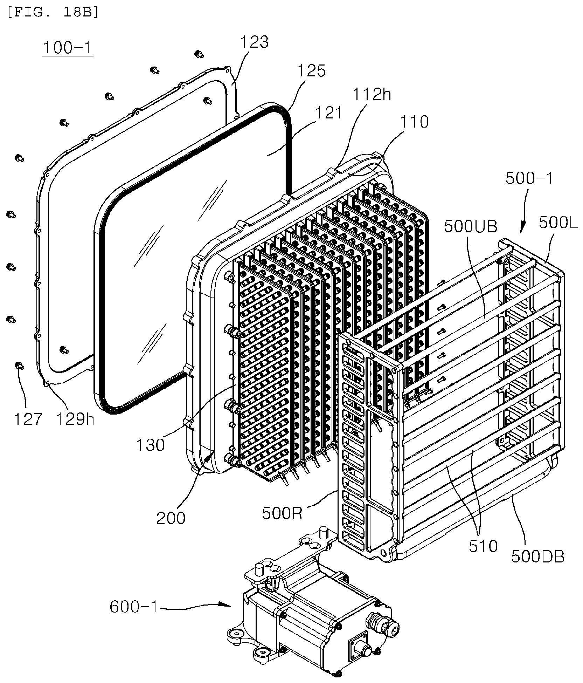

FIG. 17 is a perspective view illustrating a lighting apparatus according to another embodiment of the present disclosure, and FIGS. 18A and 18B are front and rear exploded perspective views for explaining a finger guard panel assembly among components of FIG. 17.

A lighting apparatus 100-1 according to another embodiment of the present disclosure, as shown in FIGS. 17 to 18B, may include a finger guard panel assembly 500-1 configured to protect the lighting body 110 and the heat dissipation unit 200 installed for heat dissipation thereof from the outside, in which the finger guard panel assembly may be implemented in a different manner from the finger guard panel assembly 500 shown in FIGS. 3A to 5.

That is, the finger guard panel assembly 500 implemented according to an implementation as shown in FIGS. 3A to 5 is entirely provided in a panel form, whereas the finger guard panel assembly 500-1 implemented according to another implementation as shown in FIGS. 17 to 18B may be modified such that a part of the configuration is replaced with support pipes 510.

More specifically, the finger guard panel assembly 500 according to another implementation may include, as shown in FIGS. 18A and 18B, a left finger guard panel 500L covering a left side of the plurality of heat dissipation units 200, a right finger guard panel 500R covering a right side of the plurality of heat dissipation units 200, a lower horizontal support bar 500DB connected to and supporting lower ends of the right finger guard panel 500R and the rear finger guard panel 500P, and an upper horizontal support bar 500UB connected to and supporting upper ends of the left finger guard panel 500L, the right finger guard panel 500R, and the rear finger guard panel 500P.

Here, among the components of the finger guard panel assembly 500-1 according to another implementation, the left finger guard panel 500L and the right finger guard panel 500R are implemented in the same panel form as the left finger guard panel 500L and the right finger guard panel 500R of the finger guard panel assembly 500 according to the above-described implementation. In addition, the lower horizontal support bar 500DB and the upper horizontal support bar 500UB similarly connect and support the lower and upper ends of the left finger guard panel 500L and the lower and upper ends of the right finger guard panel 500R in the left-right horizontal direction.

However, the finger guard panel assembly 500-1 according to another implementation does not separately include the upper finger guard panel 500T and the rear finger guard panel 500P among the components of the finger guard panel assembly 500 of the above-described implementation. Instead, it may further include a plurality of support pipes 510 arranged horizontally in the left-right direction. The plurality of support pipes 510 may be coupled to the upper ends of the left finger guard panel 500L and the right finger guard panel 500R at at least two positions spaced apart from each other in the front-rear direction, and may also be coupled to rear ends of the left finger guard panel 500L and the right finger guard panel 500R at a plurality of positions spaced apart from each other in the vertical direction.

Here as well, it should be understood that the lower horizontal support bar 500DB may be formed with a seating groove 505 extending in the left-right direction to accommodate the air vent tube 270 among the components of the heat dissipation unit 200.

According to the lighting apparatus 100 according to an embodiment of the present disclosure having the above-described configuration, concentration of heat generated from the LED unit 150 on a central portion may be eliminated, and effective heat dissipation may be achieved without structural modification through the heat dissipation unit 200 including the plurality of heat conduction panel bodies 200 made of SUS and employing a refrigerant phase-change method that maximizes heat dissipation efficiency.

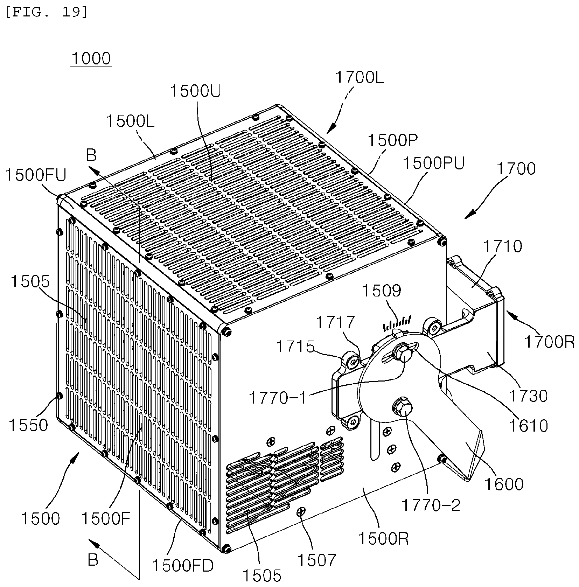

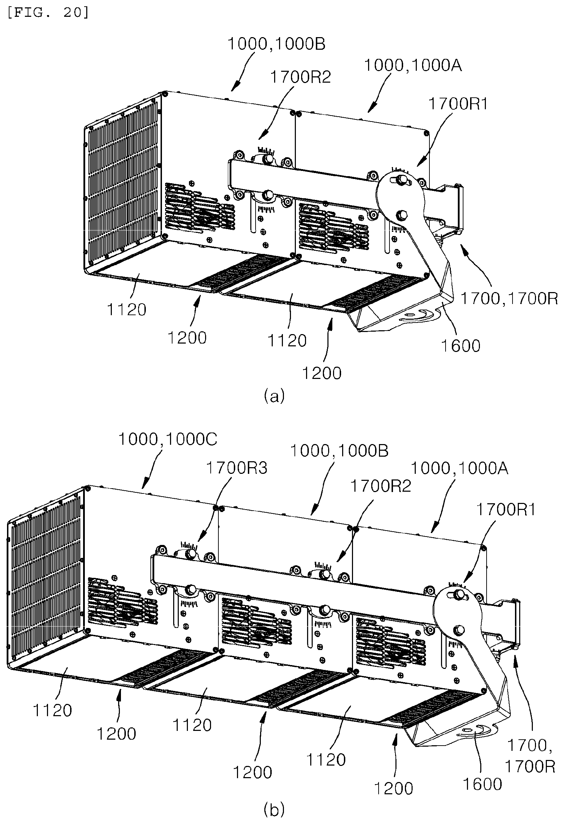

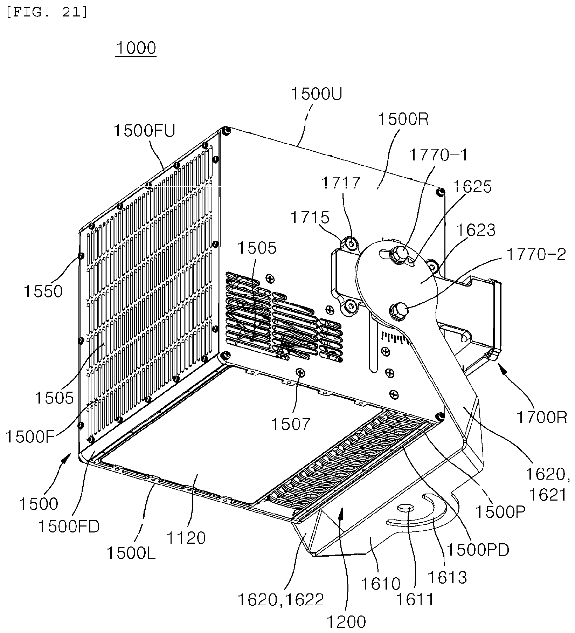

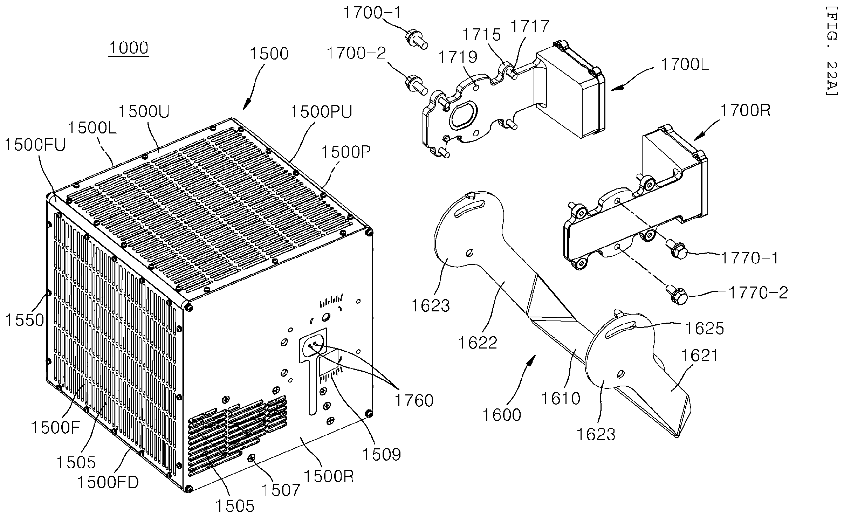

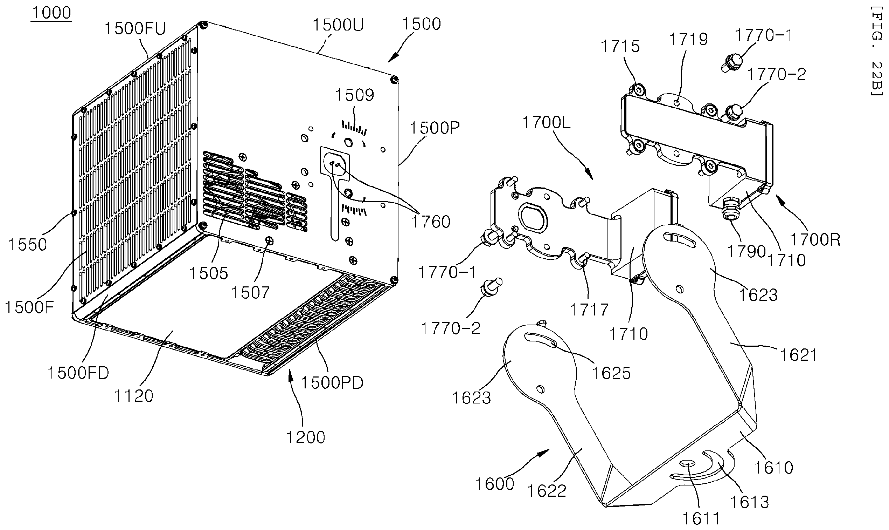

FIG. 19 is a downward perspective view illustrating a lighting apparatus according to another embodiment of the present disclosure, FIG. 20 is a perspective view illustrating a use example of a lighting apparatus according to another embodiment of the present disclosure, FIG. 21 is an upward perspective view illustrating a lighting apparatus according to another embodiment of the present disclosure, FIGS. 22A and 22B are downward and upward exploded perspective views illustrating a coupled state by an electronic-component storage frame and a tilting bracket portion among components of FIGS. 19 and 21, FIGS. 23A and 23B are front and rear exploded perspective views illustrating the electronic-component storage frame among the components of FIGS. 19 and 21, and FIGS. 24A and 24B are front and rear exploded perspective views illustrating the finger guard panel assembly among the components of FIGS. 19 and 21.

A lighting apparatus 1000 according to another embodiment of the present disclosure, as shown in FIGS. 19 to 24B, includes an LED unit 1150 and a heat dissipation unit 1200 according to a second implementation, which are protected from the outside by a finger guard panel assembly 1500 having a box (or hexahedral) shape except for a lower surface.

Unlike the lighting apparatus 100 according to an embodiment of the present disclosure, which is provided in the form of a spot light requiring concentrated light distribution such that light emitted from the LED unit 150 directly passes through the light-transmitting panel 120, the lighting apparatus 1000 according to another embodiment of the present disclosure employs a color-rendering reflector method (see a reflecting panel 1112 described below) to improve the light distribution efficiency of light emitted from the LED unit 1150 having a relatively narrow area.

The LED unit 1150 may also be configured with specifications different from those of the lighting apparatus 100 according to an embodiment of the present disclosure, which is the spot light. However, in the lighting apparatus 1000 according to another embodiment of the present disclosure as well, it is sufficient to understand that the LED unit 1150 is an essential component of a general lighting apparatus that generates predetermined light by a plurality of LED elements when power is supplied and irradiates the light in a direction desired by a user.

Meanwhile, the heat dissipation unit 1200 according to the second implementation may rapidly exchange heat generated from the LED unit 1150 with outside air (outdoor air) to dissipate heat, thereby improving light distribution performance of the LED unit 1150 as well as enhancing its durability.

As shown in FIGS. 19 and 20, the lighting apparatus 1000 according to another embodiment of the present disclosure may be installed at a location requiring illumination, for example via a support pole (not shown), through a pair of electronic-component storage frames 1700 coupled to surround the right and left rear ends and a portion of the rear surface among the outer surfaces of the finger guard panel assembly 1500, and a tilting bracket portion 1600 fixed to the pair of electronic-component storage frames 1700 and coupled to tiltably rotate the entire finger guard panel assembly 1500 about a left-right horizontal axis.

Here, since heat discharged from the heat dissipation unit 1200 according to the second implementation accommodated inside the finger guard panel assembly 1500 is relatively high, the finger guard panel assembly 1500 may serve as a safety structure to protect an installer (or user) from injury such as burns caused by the high temperature. In addition, the finger guard panel assembly 1500 may protect the heat dissipation unit 1200 according to the second implementation from the outside by preventing surrounding structures from directly contacting it.

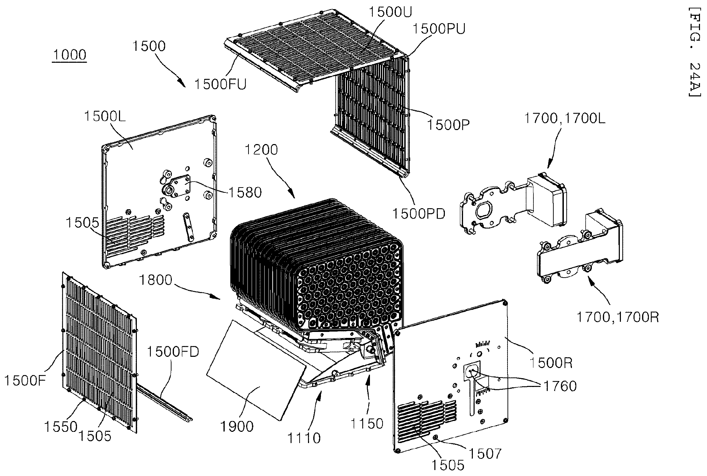

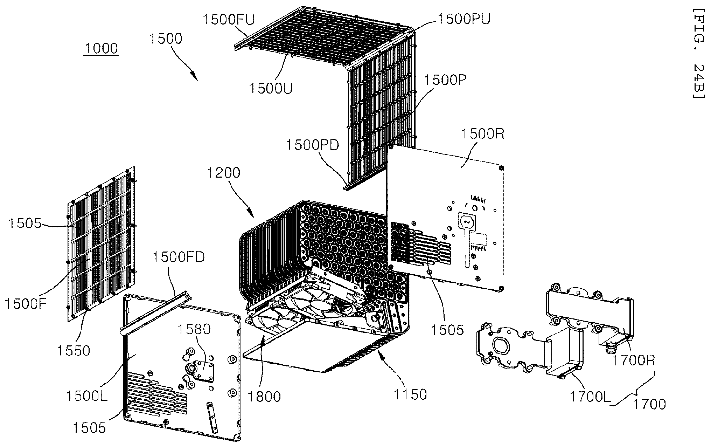

More specifically, as shown in FIGS. 24A and 24B, the finger guard panel assembly 1500 has a hexahedral shape formed by five panels and is arranged to cover all portions except a lower surface, which is a direction in which light is emitted by the LED unit 1150. The pair of electronic-component storage frames 1700 are respectively coupled to left and right side surfaces of the finger guard panel assembly 1500, and opposite ends of the tilting bracket portion 1600 may pass through the pair of electronic-component storage frames 1700 and be coupled to the left and right side surfaces of the finger guard panel assembly 1500.

Here, as shown in FIGS. 21A and 21B, the pair of electronic-component storage frames 1700 may include a right storage frame 1700R fixed to the right side surface of the finger guard panel assembly 1500 and a left storage frame 1700L fixed to the left side surface of the finger guard panel assembly 1500.

Hereinafter, since the pair of electronic-component storage frames 1700 have identical configurations except for their coupling positions to the finger guard panel assembly 1500, as shown in FIGS. 22A and 22B, the right electronic-component storage frame 1700R will mainly be described, and a description of the left electronic-component storage frame 1700L will be omitted.

The right electronic-component storage frame 1700R may include a frame body 1710 bent into a substantially "L" shape so as to be in close contact with a rear portion of the finger guard panel assembly 1500 and simultaneously in close contact with a right side surface of the finger guard panel assembly 1500.

A portion of the frame body 1710 corresponding to the rear portion side of the finger guard panel assembly 1500 may be formed in a substantially rectangular parallelepiped shape, and a first electronic-component accommodating portion 1705-1 may be provided therein. In addition, a portion of the frame body 1710 corresponding to the right side surface of the finger guard panel assembly 1500 may be formed in a panel shape having a relatively small thickness in the left-right direction, and a second electronic-component accommodating portion 1705-2 may be provided therein.

The first electronic-component accommodating portion 1705-1 may be provided as a substantially rectangular parallelepiped empty space. A power cable (not shown) may be connected to the first electronic-component accommodating portion 1705 through a connection terminal 1790 provided externally, and an internal wire (not shown) electrically connected to the power cable may be arranged to extend to the second electronic-component accommodating portion 1705-2. The first electronic-component accommodating portion 1705-1 may be shielded by a first accommodating-portion cover 1720.

Meanwhile, an electrical PCB 1750 may be accommodated inside the second electronic-component accommodating portion 1705-2. In order to prevent ingress of external moisture and the like, the electrical PCB 1750 may be sealed by an embedded waterproof film 1740, and the second electronic-component accommodating portion 1705-2 may be shielded by a second accommodating-portion cover 1730.

The right electronic-component storage frame 1700R configured as described above may be fixed to a screw panel fastening hole 1515 formed in a right finger guard panel 1500R, which will be described later and corresponds to the right side surface of the finger guard panel assembly 1500, through a plurality of fixing screws 1717 passing through frame through-holes 1715 formed at a plurality of locations (four locations) along a peripheral edge thereof.

In addition, as shown in FIGS. 22A and 22B, the right electronic-component storage frame 1700R may be formed with a pair of fixing bolt through-holes 1719 for fixed installation of the tilting bracket portion 1600. Of the pair of fixing bolt through-holes 1719, a central fixing bolt 1770-2 serving as a central hinge for tilting rotation may be installed to pass through one thereof, and a hinge fixing bolt 1770-1 passing through a tilting rotation guide slot 1625 formed in the tilting bracket portion 1600 may be installed to pass through the other thereof.

As shown in FIGS. 22A and 22B, the tilting bracket portion 1600 may include a fixing panel 1610 fixed to the installation structure such as the support pole (not shown), and a right connection panel 1621 and a left connection panel 1622 bent and extending from opposite left and right ends of the fixing panel 1610 and connected to right and left sides of the finger guard panel assembly 1500 via the right electronic-component storage frame 1700R and the left electronic-component storage frame 1700L, respectively.

Here, ends of the right connection panel 1621 and the left connection panel 1622 may be formed in a circular panel shape (see reference numeral 1623), and the above-described tilting rotation guide slot 1625 may be formed therein.

Such a tilting bracket portion 1600 performs a function similar to that of the angle adjustment unit 600 among the components of the lighting apparatus 100 according to an embodiment of the present disclosure described above. However, the angle adjustment unit 600 in the embodiment 100 of the present disclosure adjusts the irradiation direction of light by performing front-rear tilting rotation and left-right steering rotation of the lighting body 110, whereas the tilting bracket portion 1600 in the lighting apparatus 1000 according to another embodiment of the present disclosure differs in that it adjusts the irradiation direction of light by performing front-rear tilting rotation of the lighting body 1100, and by allowing the tilting bracket portion 1600 itself to be steered left and right and then fixed in position.

Here, a fixing end 1612 for fixation to the installation structure such as the support pole may be formed to protrude from a middle portion of the fixing panel 1610 in a semicircular panel shape. The fixing end 1612 may be formed with a bolt fixing hole 1611 for fastening to the support pole using a fixing bolt (not shown), and a steering guide slot 1613 for fastening a steering guide bolt (not shown) for steering rotation.

Meanwhile, a pair of power pin contact portions 1756 may be provided on the electrical PCB 1750 accommodated in each of the second electronic-component accommodating portions 1705-2 of the right electronic-component storage frame 1700R and the left electronic-component storage frame 1700L. In addition, a pair of power pins 1560 electrically connected to the pair of power pin contact portions 1756 described above may be formed to pass through the right finger guard panel 1500R and the left finger guard panel 1500L of the finger guard panel assembly 1500, to which the right electronic-component storage frame 1700R and the left electronic-component storage frame 1700L are closely coupled, so as to extend between the interior and exterior thereof.

The pair of electronic-component storage frames 1700 configured as described above may be formed to have different lengths in the front-rear direction, as shown in FIG. 20(a), and second electronic-component accommodating portions 1705-2 may be formed at two positions spaced apart from each other to simultaneously connect two lighting apparatuses 1000A and 1000B arranged continuously in the front-rear direction (see reference numerals 1700R1 and 1700R2 in FIG. 20).

Further, as shown in FIG. 20(b), the pair of electronic-component storage frames 1700 may include second electronic-component accommodating portions 1705-2 formed at three positions spaced apart from each other to simultaneously connect three lighting apparatuses 1000A, 1000B, and 1000C arranged continuously in the front-rear direction (see reference numerals 1700R1, 1700R2, and 1700R3 in FIG. 20).

However, the pair of electronic-component storage frames 1700 are not necessarily required to be provided so as to protrude outward from the left finger guard panel 1500L, the right finger guard panel 1500R, or the rear finger guard panel 1500P, as shown in FIGS. 22A to 24B. Instead, they may be applied in another implementation to be described later in which the frames are embedded and recessed within either the left finger guard panel 1500L or the right finger guard panel 1500R.

The specific configuration and coupling structure of the electronic-component storage frame 1700-1 implemented according to another implementation will be described in greater detail later.

The finger guard panel assembly 1500 has a hexahedral shape except for the lower surface corresponding to a light irradiation direction of the LED unit 1150, and more specifically, may be provided as a combination of the following detailed components.

That is, as shown in FIGS. 24A and 24B, the finger guard panel assembly 1500 may include a rear finger guard panel 1500P forming a rear exterior of the hexahedral shape described above, an upper finger guard panel 1500U forming an upper exterior, a front finger guard panel 1500F forming a front exterior, and the above-described right finger guard panel 1500R and left finger guard panel 1500L.

In addition, the finger guard panel assembly 1500 may further include a rear lower panel bar 1500PD coupled to a lower end of the rear finger guard panel 1500P to form a frame structure, a rear upper panel bar 1500PU mediating connection between an upper end of the rear finger guard panel 1500P and a rear end of the upper finger guard panel 1500U, a front upper panel bar 1500FU mediating connection between a front end of the upper finger guard panel 1500U and an upper end of the front finger guard panel 1500F, and a front lower panel bar 1500FD coupled to a lower end of the front finger guard panel 1500F to form a frame structure.

Here, screw fastening holes (no reference numeral assigned) for screw coupling by fixing screws 1550 passing through screw through-holes (no reference numeral assigned) of the right finger guard panel 1500R and the left finger guard panel 1500L may be formed on left and right ends of each of the panel bars 1500PD, 1500PU, 1500FU, and 1500FD of the finger guard panel assembly 1500.

In addition, each of the panel bars 1500PD, 1500PU, 1500FU, and 1500FD of the finger guard panel assembly 1500 may be formed with screw fastening holes (no reference numeral assigned) into which the plurality of panel fixing screws 1550 are inserted and fastened through screw through-holes (no reference numeral assigned) formed at peripheral edges of the respective panels of the finger guard panel assembly 1500.

Meanwhile, each panel of the finger guard panel assembly 1500 may be formed with a plurality of ventilation holes 1505 in a slot shape (or grill shape) to allow inflow of outside air (outdoor air) and outflow of inside air (indoor air). However, the plurality of ventilation holes 1505 are not necessarily required to be formed in the slot shape, and may alternatively be formed in a circular hole shape.

Here, among the components of the finger guard panel assembly 1500, the right finger guard panel 1500R and the left finger guard panel 1500L may be formed with a plurality of ventilation holes 1505 only in portions not occupied by one-side heat conduction panel 1200-1 and the other-side heat conduction panel 1200-2 among the components of the heat dissipation unit 1200 to be described later, that is, in portions where supply of outdoor air to a blower unit 1800 described later is smooth. It is preferable that the remaining panels-the rear finger guard panel 1500P, the upper finger guard panel 1500U, and the front finger guard panel 1500F-be formed with a plurality of ventilation holes 1505 in a grill mesh form over substantially their entire areas.

Meanwhile, inner surfaces of the right finger guard panel 1500R and the left finger guard panel 1500L may be provided with a DC PCB housing 1580 in which a DC PCB for electrical connection to the electrical PCB 1750 embedded in the right electronic-component storage frame 1700R and the left electronic-component storage frame 1700L among the components of the pair of electronic-component storage frames 1700 is accommodated.

In addition, angle indicators 1509 for indicating a tilting rotation angle by the tilting bracket portion 1600 may be printed on outer surfaces of the right finger guard panel 1500R and the left finger guard panel 1500L.

Meanwhile, the right finger guard panel 1500R and the left finger guard panel 1500L may be formed with a plurality of screw through-holes (no reference numeral assigned) for fixing the heat dissipation unit 1200 installed therein, the lighting body 1100 and the blower unit 1800. The above-described components may be fixed by a plurality of fixing screws 1507 passing through the screw through-holes.

Here, the finger guard panel assembly 1500 is not necessarily required to have the front finger guard panel 1500F, the upper finger guard panel 1500U, and the rear finger guard panel 1500P formed in a grill shape for preventing burns to a worker, as shown in FIGS. 4A to 6B.

That is, as in a lighting apparatus 1000-1 according to another embodiment of the present disclosure to be described later, since the device is installed at a high position such as on the support pole (not shown) during operation that normally involves heat generation, there is little need to prevent burns to a worker, and thus a part of the configuration may be replaced with support pipes 1500C-P described later in order to further enhance outdoor air circulation to the internal heat dissipation unit 1200.

Replacement of the configuration by the support pipes 1500C-P will be described in greater detail later.

In addition, the lighting apparatus 1000 according to an embodiment of the present disclosure may further include a visor panel 1900 for improving light spread of light emitted from the LED unit 1150, as shown in FIG. 24A.

The visor panel 1900 may be configured such that an end thereof is insertable and retractable in a downwardly inclined linear direction through a space between a front end of the lighting body 1110 and a lower end of the front finger guard panel 1500F.

More specifically, the visor panel 1900 may be inclinedly arranged such that a distal end thereof protrudes forward and downward beyond at least a surface of a transmission window panel 1120 forming a lower surface of the lighting body 1110. The spread degree of light emitted from the LED unit 1150 may be adjusted according to a downward protrusion amount of the end of the visor panel 1900.

Here, although not shown, the right finger guard panel 1500R and the left finger guard panel 1500L may be further provided with a visor guide structure (not shown) for guiding movement of the visor panel 1900.

For reference, the visor guide structure may be implemented by forming ventilation holes 1505 in the right finger guard panel 1500R and the left finger guard panel 1500L to have a shape corresponding to a movement path of the visor panel 1900, and adjusting an end position of the visor panel 1900 by fastening and loosening screws that secure the visor panel 1900 to the ventilation holes 1505.

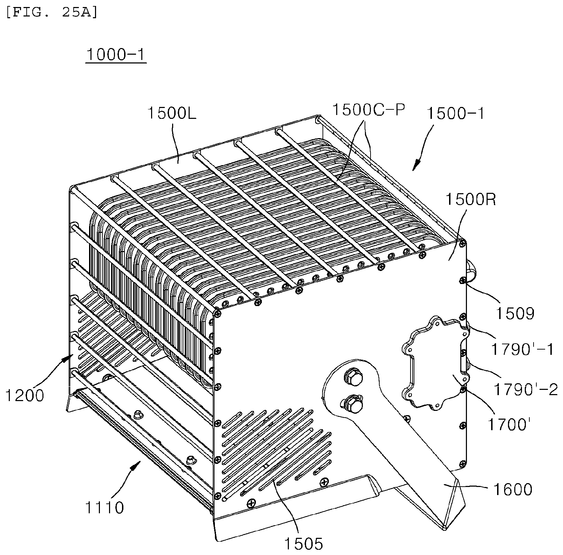

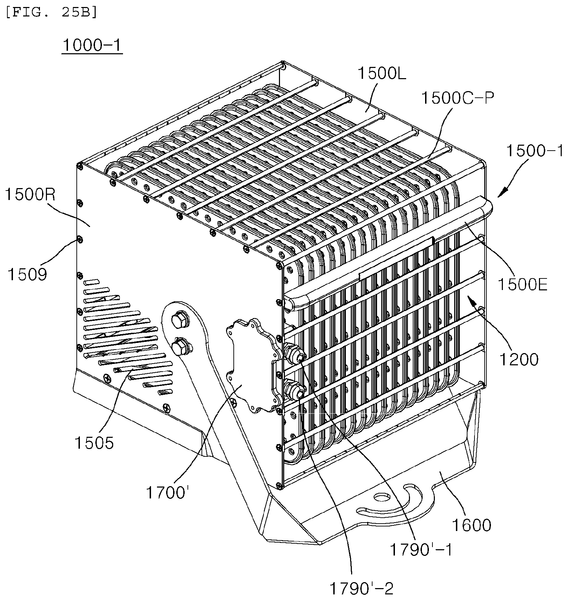

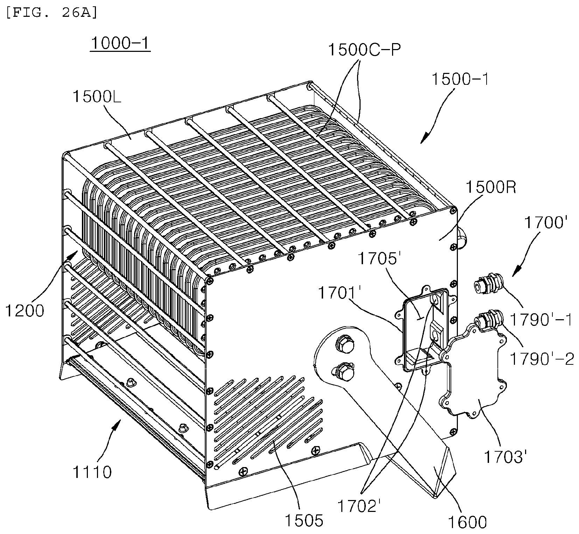

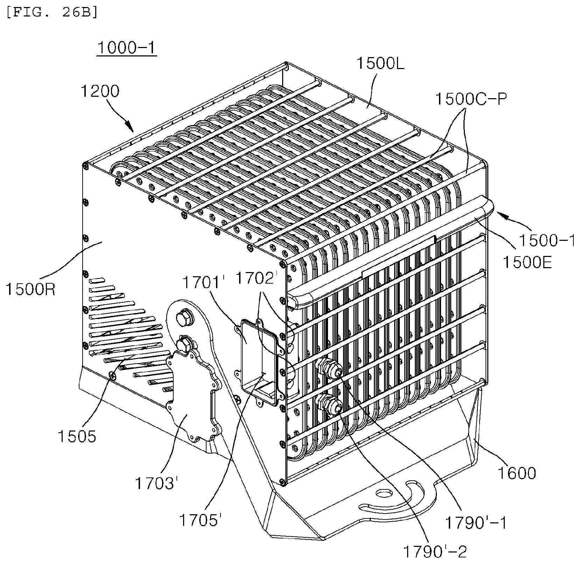

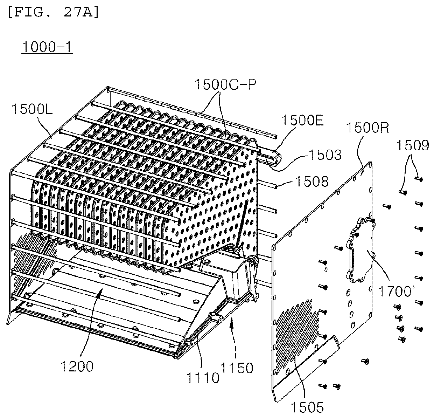

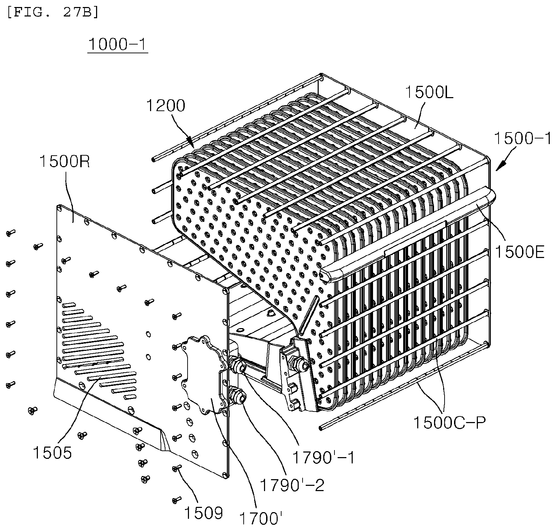

FIGS. 25A and 25B are front and rear perspective views illustrating a lighting apparatus according to another embodiment of the present disclosure, FIGS. 26A and 26B are front and rear exploded perspective views illustrating an electronic-component storage frame implemented according to another implementation among components of FIGS. 25A and 25B, and FIGS. 27A and 27B are front and rear exploded perspective views illustrating a finger guard panel assembly implemented according to another implementation among the components of FIGS. 25A and 25B.

A lighting apparatus 1000-1 according to another embodiment of the present disclosure may include an electronic-component storage frame 1700' according to another implementation and a finger guard panel assembly 1500-1 according to another implementation, as shown in FIGS. 25A to 27B.

First, as shown in FIGS. 25A to 26B, the electronic-component storage frame 1700' according to another implementation may be embedded and recessedly attached to an interior of either the left finger guard panel 1500L or the right finger guard panel 1500R. In the drawings, the electronic-component storage frame 1700' according to another implementation is illustrated as being installed in the right finger guard panel 1500R, but it should be understood that it may alternatively be installed in the left finger guard panel 1500L.

More specifically, the electronic-component storage frame 1700' according to another implementation may include a storage frame body 1701' configured to form an electronic-component accommodating portion 1705' in an embedded manner inside an insertion hole (no reference numeral assigned) formed in the right finger guard panel 1500R, a terminal fixing portion 1702' formed on the storage frame body 1701' and provided for signal connection of a pair of connection terminals 1790' to be described later, and an accommodating-portion cover 1703' coupled to cover the electronic-component accommodating portion 1705' of the storage frame body 1701' from the outside.

In addition, a pair of terminal fixing portions 1702' may be provided on an inner surface of a rear portion defining the electronic-component accommodating portion 1705' to be vertically spaced apart from each other, and the pair of connection terminals 1790' connected to a power cable (not shown) may be fixed through the pair of terminal fixing portions 1702'.

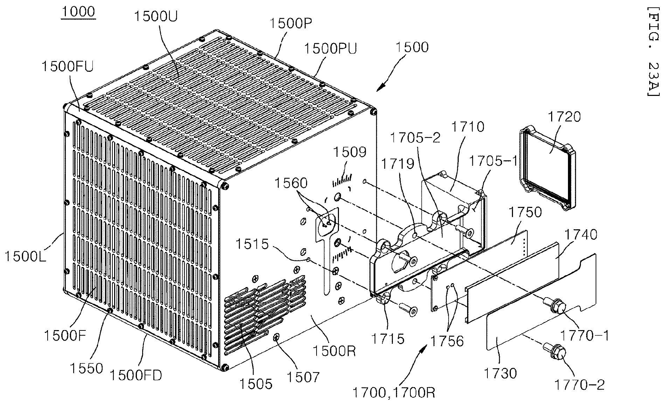

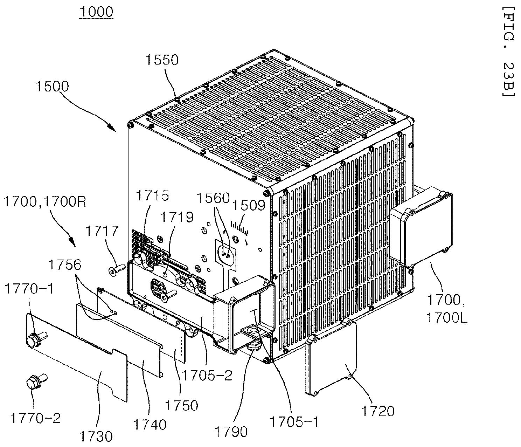

In the case of the electronic-component storage frame 1700 described above with reference to FIGS. 23A and 23B, the left electronic-component storage frame 1700L and the right electronic-component storage frame 1700R are respectively provided on the left finger guard panel 1500L and the right finger guard panel 1500R. In contrast, the electronic-component storage frame 1700' according to another implementation is implemented to be formed only on the right finger guard panel 1500R, and differs in that the above-described power cable, without distinction between an input side and an output side, may be fixed through the pair of terminal fixing portions 1702' of the electronic-component accommodating portion 1705' concentrically installed on the right finger guard panel 1500R.

In addition, in the case of the electronic-component storage frame 1700' according to another implementation, unlike the electronic-component storage frame 1700 described above with reference to FIGS. 23A and 23B, a configuration corresponding to the electronic-component accommodating portion 1705' is formed on an inner side of the right finger guard panel 1500R. Thus, interference during tilting rotation of the tilting bracket portion 1600 may be minimized, and an increase in overall volume of the product in the left-right direction may be prevented.

Meanwhile, as shown in FIGS. 25A and 25B and FIGS. 27A and 27B, the finger guard panel assembly 1500-1 according to another implementation may be implemented in a form in which some of the panel-type components of FIGS. 1 to 6B (e.g., the front finger guard panel 1500F, the upper finger guard panel 1500U, and the rear finger guard panel 1500P), which are provided to protect the lighting body 1110 and the heat dissipation unit 1200 installed for heat dissipation thereof from the outside, are replaced with a plurality of support pipes 1500C-P.

More specifically, as shown in FIGS. 25A to 27B, the finger guard panel assembly 1500-1 according to another implementation may include a left finger guard panel 1500L covering a left side of the plurality of heat dissipation units 1200, a right finger guard panel 1500R covering a right side of the plurality of heat dissipation units 1200, and a plurality of support pipes 1500C-P connecting the left finger guard panel 1500L and the right finger guard panel 1500R so as to be horizontally arranged at predetermined intervals along front ends, upper ends, and rear ends thereof except for lower ends thereof.

Screw fastening holes 1508, into which a plurality of panel fixing screws 1509 are respectively inserted and fastened from the outside through the left finger guard panel 1500L and the right finger guard panel 1500R, may be formed at opposite left and right ends of the plurality of support pipes 1500C-P.

Meanwhile, one of the plurality of support pipes 1500C-P may be replaced with a horizontal support bar 1500E having a seating groove 1503 formed to accommodate an air vent tube 1270 among the components of the heat dissipation unit 1200 described later.

The horizontal support bar 1500E may have opposite ends supported and coupled to inner surfaces of the left finger guard panel 1500L and the right finger guard panel 1500R, respectively. By accommodating the air vent tube 1270 of the heat dissipation unit 1200 and protecting it from the outside, the horizontal support bar may serve to prevent damage to the air vent tube 1270 protruding rearward during movement or due to external force.

Here, the plurality of support pipes 1500C-P may be provided with relatively narrow spacing between adjacent components so as to prevent burn injuries to a worker. However, since the lighting apparatuses 1000 and 1000-1 according to the present disclosure are generally installed at elevated locations, such as on a support pole (not shown) installed in a place requiring illumination, the necessity for preventing burns to a worker is relatively low. Thus, the support pipes may be designed to have sufficient spacing therebetween so as to further enhance heat exchange between the heat dissipation unit 1200 and outdoor air.

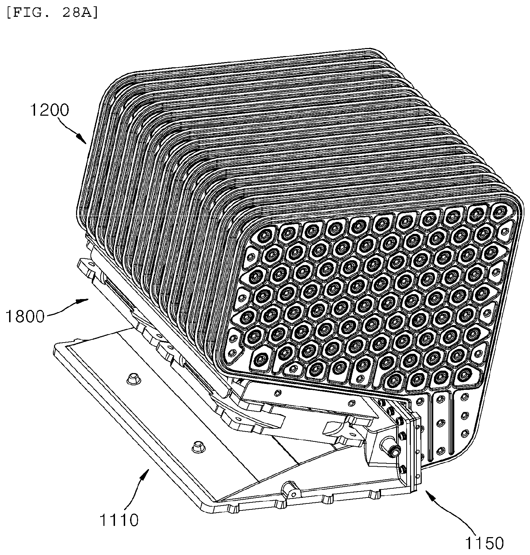

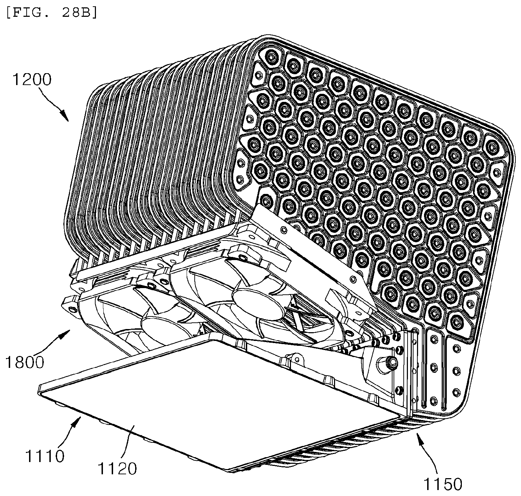

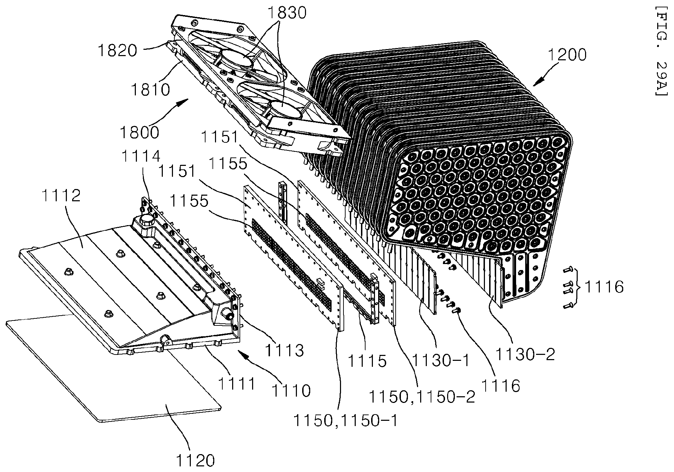

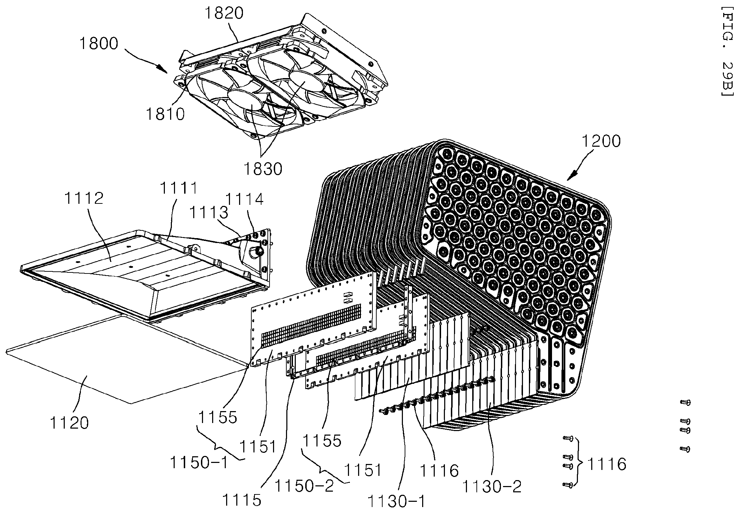

FIGS. 28A and 28B are downward and upward perspective views illustrating a state in which the finger guard panel assembly is excluded among the components of FIGS. 19 and 21, and FIGS. 29A and 29B are exploded perspective views of FIGS. 28A and 28B.

A lighting apparatus 1000 according to another embodiment of the present disclosure, as shown in FIGS. 28A to 29B, may include an LED unit 1150 coupled inside the finger guard panel assembly 1500 through a lighting body 1110, and a heat dissipation unit 1200 according to a second implementation configured to receive and dissipate heat generated from the LED unit 1150.

Here, the lighting body 1110 may include a bracket frame portion 1111 having a substantially quadrangular frame shape and penetrating in a vertical direction, a mounting panel 1113 bent and extending from a rear end of the bracket frame portion 1111 and coupled in surface contact with an LED board mounting block 1151 to be described later, a reflecting panel 1112 connecting a front end of the bracket frame portion 1111 and an upper end of the mounting panel 1113 and reflecting light emitted from a plurality of LED elements 1155 to be described later, and a transparent or translucent transmission window panel 1120 provided to cover an open surface of the bracket frame portion 1111 and to transmit light emitted from the LED elements 1155 or reflected by the reflecting panel 1112.

A screw assembly frame 1115 for mediating screw assembly of the LED board mounting block 1151 may be additionally disposed on a rear surface of the mounting panel 1113. The LED mounting block 1151 may be fixed by an operation in which a plurality of assembly screws 1116 pass through screw through-holes 1115h formed in the screw assembly frame 1115 from rear to front and are fastened to the mounting panel 1113 of the lighting body 1110.

The bracket frame portion 1111 may be fixed to an inner side of the finger guard panel assembly 1500 through a plurality of fixing screws 1507.

Meanwhile, a blower unit 1800 may be further installed in an interior shielded by the lighting body 1110 and the finger guard panel assembly 1500.

The blower unit 1800 may serve to promote air circulation between hot air (indoor air) discharged through the heat dissipation unit 1200 to be described later and outdoor air introduced through ventilation holes 1505 of the front finger guard panel 1500F, the right finger guard panel 1500R, and the left finger guard panel 1500L of the finger guard panel assembly 1500.

The blower unit 1800 may include a panel fixing bracket 1810, a fan installation bracket 1820 connected to the panel fixing bracket 1810 and configured to mediate installation of a blower fan 1830 to be described later, and at least one blower fan 1830 fixed to the fan installation bracket 1820 and provided with a plurality of electrically driven blowers.

In addition, the blower unit 1800 may be positioned relatively lower in the direction of gravity in the heat dissipation unit 1200 to be described later and operated to form a blowing airflow toward the upper side or the rear upper side, thereby allowing hot air discharged by the heat dissipation unit 1200 to be more rapidly exhausted from the interior and allowing outdoor air to be introduced through the rear finger guard panel 1500P having the ventilation holes 1505 in a grill mesh form, the upper finger guard panel 1500U forming an upper exterior, and the front finger guard panel 1500F forming a front exterior.

For reference, the heat dissipation unit 1200 according to the second implementation may be provided in a form of a panel-type heat exchanger ("heat sink fin") and may be arranged inside the finger guard panel assembly 1500 so as to be spaced apart from each other by a predetermined distance in the left-right direction.

In this case, it is preferable that the blower unit 1800 be configured such that, after drawing in outdoor air through the ventilation holes 1505 of the front finger guard panel 1500F, the right finger guard panel 1500R, and the left finger guard panel 1500L, the blowing direction is set so that the air is exhausted through the rear finger guard panel 1500P on the rear side via spaces between the heat dissipation units 1200 arranged to be spaced apart from each other by a predetermined distance in the left-right direction.

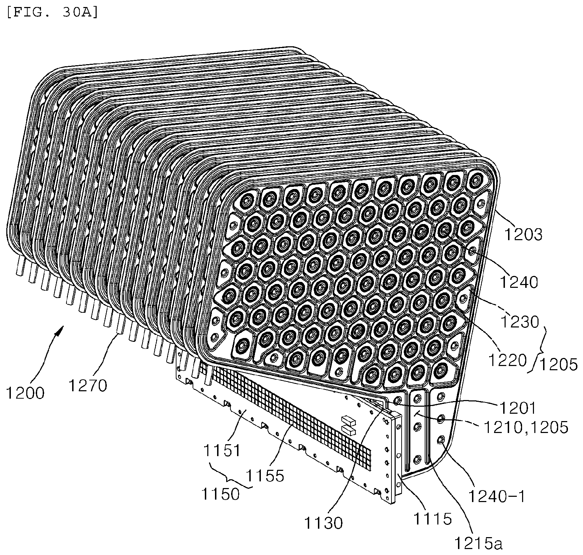

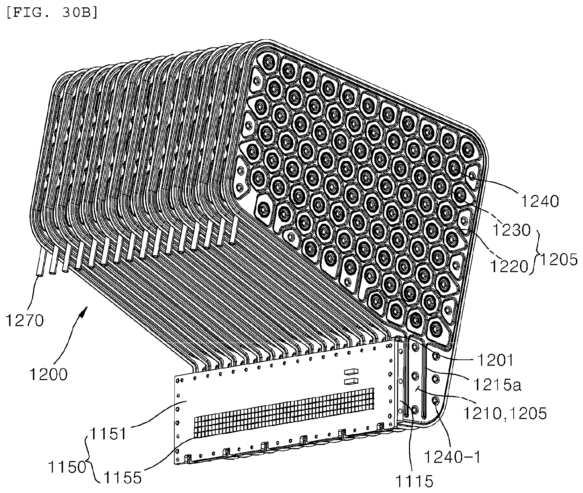

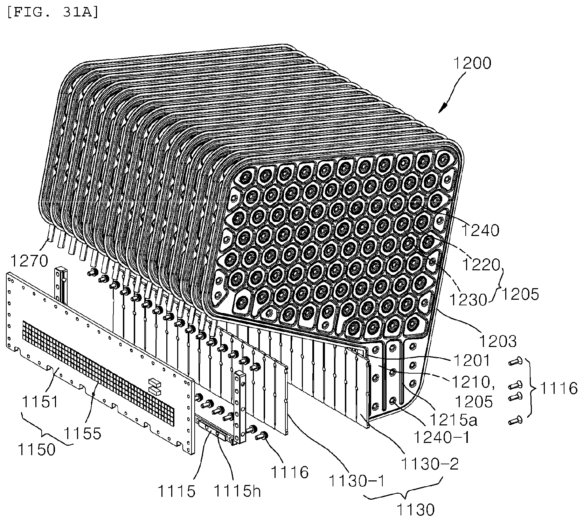

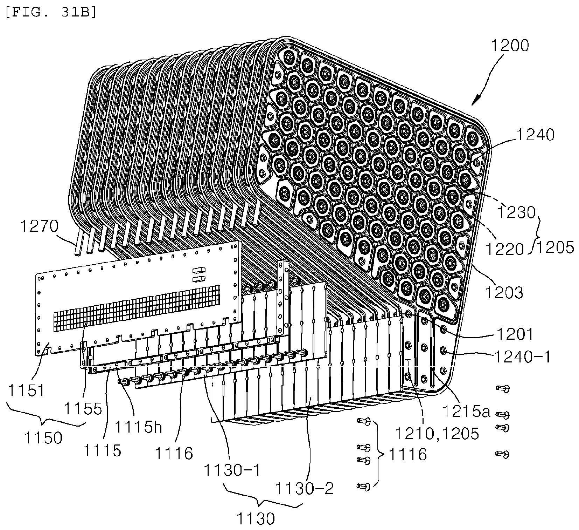

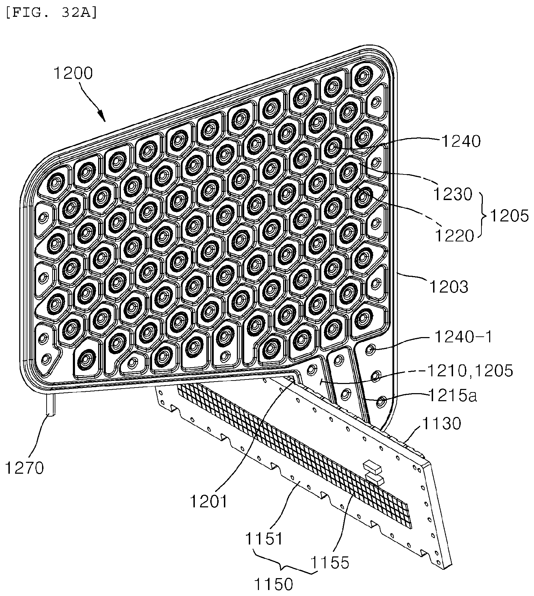

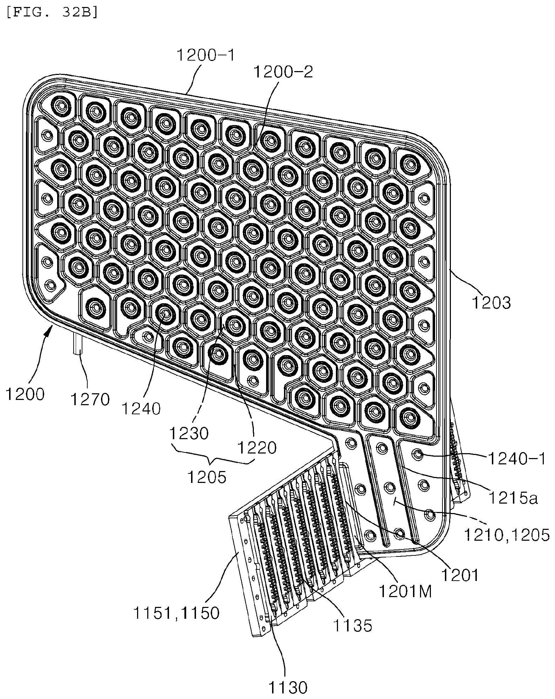

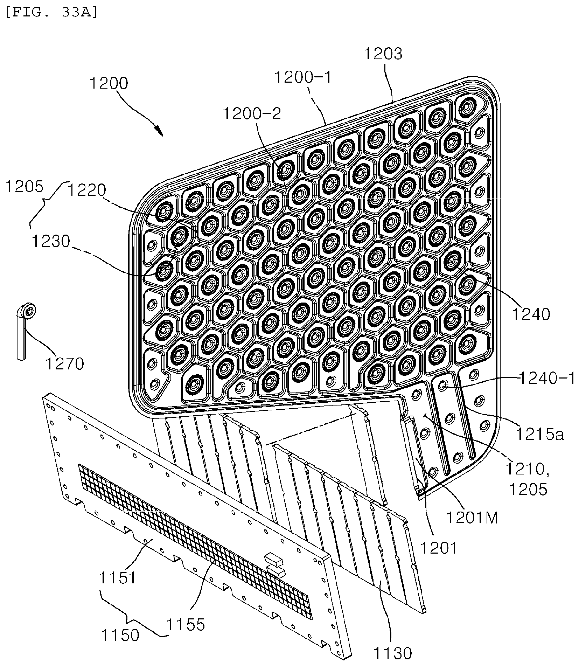

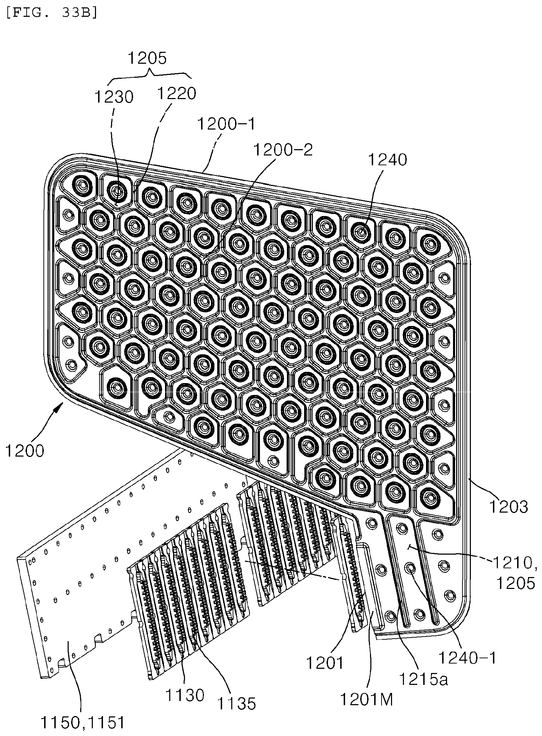

FIGS. 30A and 30B are downward and upward perspective views illustrating a state in which the lighting body and the blower unit are excluded among the components of FIGS. 28A and 28B, FIGS. 31A and 31B are exploded perspective views of FIGS. 30A and 30B, respectively, illustrating an exploded state of an LED unit, FIGS. 32A and 32B are front and rear perspective views illustrating a coupled state of an LED unit to a single heat dissipation unit among the components of FIGS. 30A and 30B, and FIGS. 33A and 33B are exploded perspective views of FIGS. 32A and 32B

As shown in FIGS. 30A to 33B, the LED unit 1150 may include an LED board mounting block 1151 provided as a metal board on which a plurality of LED elements 1155 are mounted.

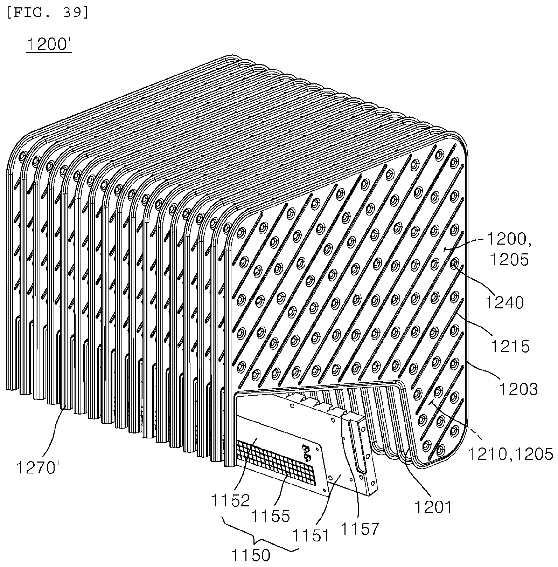

However, according to the embodiment, the LED unit 1150 is not necessarily required to be provided as a metal board in which the LED elements 1155 are directly mounted on the LED board mounting block 1151. Rather, the LED unit 1150 may be provided in the form of a panel made of a metal member capable of ordinary heat transfer, and the LED elements 1155 may be mounted on a separate LED board 1152 (see FIG. 39) described later) formed of a metal material, such that heat transfer is mediated through the LED board mounting block 1151.

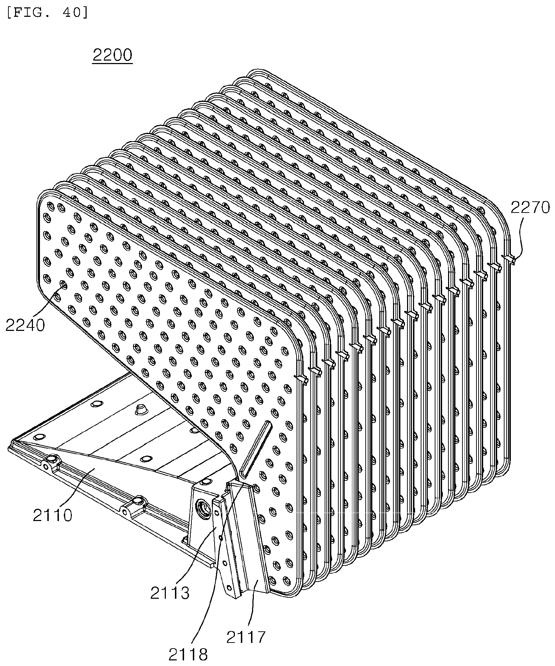

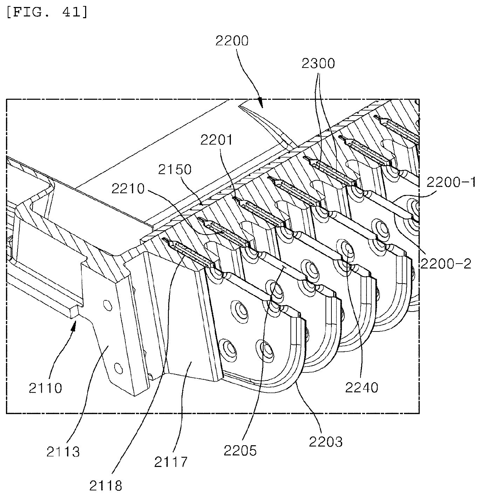

In addition, as shown in FIGS. 40 and 41 to be described later, the LED board mounting block 1151 is not necessarily required for installation of the LED unit 2150. Instead, the LED unit 2150 may be directly mounted in surface contact with a mounting panel 2113 integrally formed at a rear end of the lighting body 2110, such that heat transfer may be performed via the mounting panel 2113.

Meanwhile, as described above, a plurality of heat dissipation units 1200 may be coupled and fixed to a single LED unit 1150 formed to extend in the left-right direction, thereby being provided in the form of one module.

In addition, as shown in FIGS. 33A and 33B, the heat dissipation unit 1200 according to the second implementation may further include a plurality of heat transfer mediating blocks 1130, which are disposed between the LED unit 1150 and a press-fit end 1201 of the heat dissipation unit 1200 to be described later and are configured to receive heat from the LED unit 1150 and transfer the heat to a heat dissipation plate portion 1203 of the heat dissipation unit 1200 to be described later.

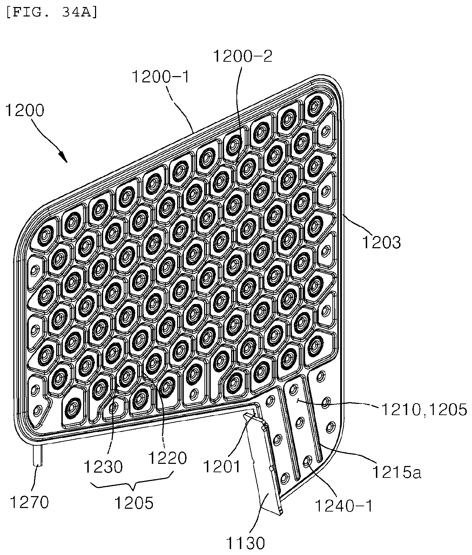

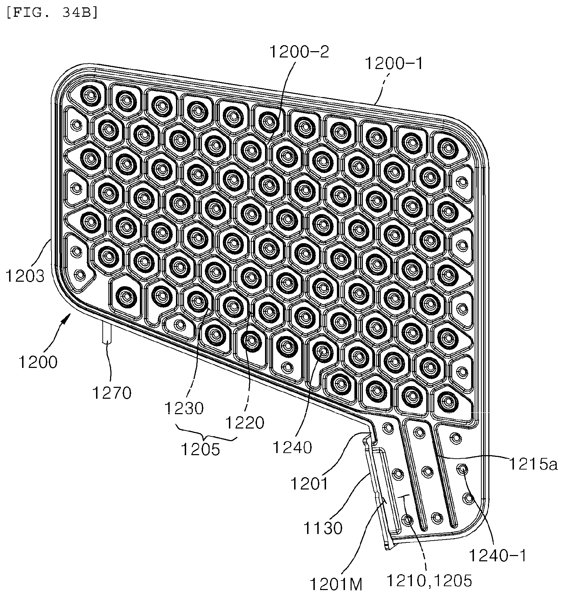

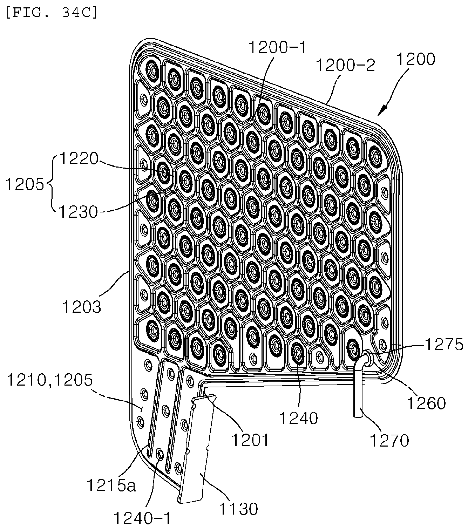

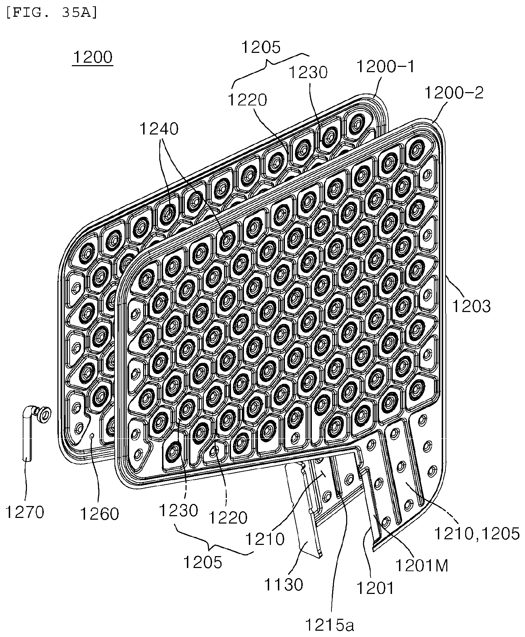

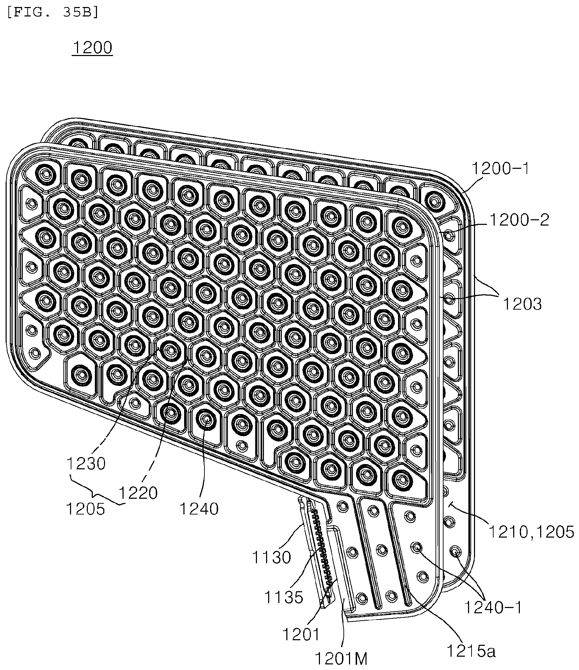

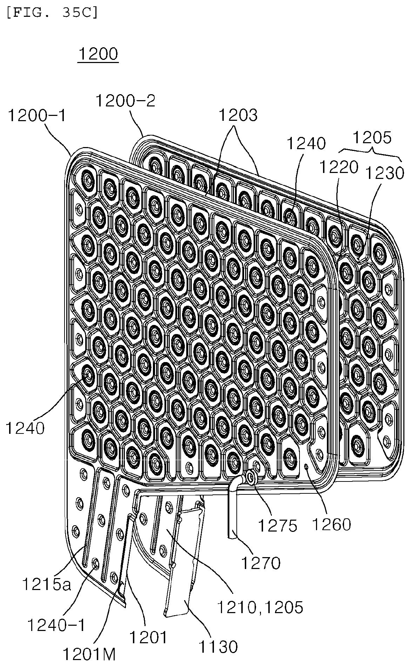

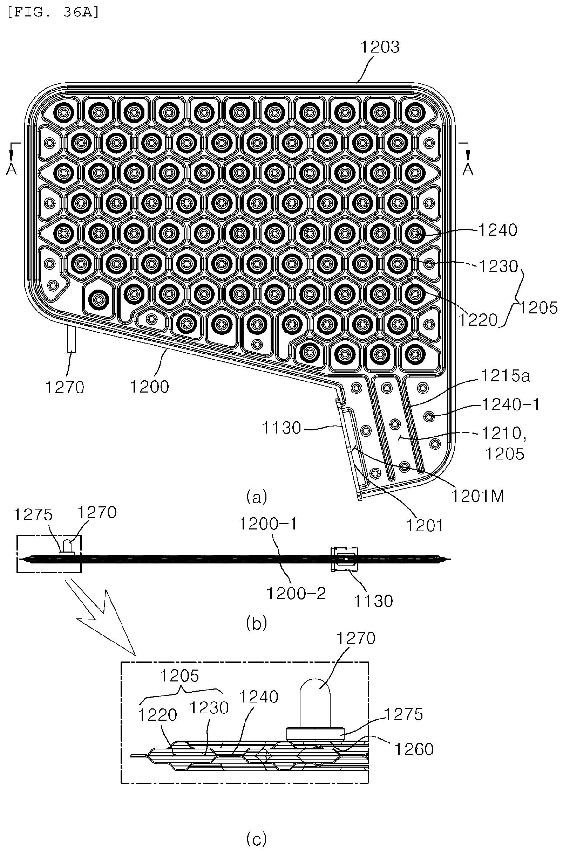

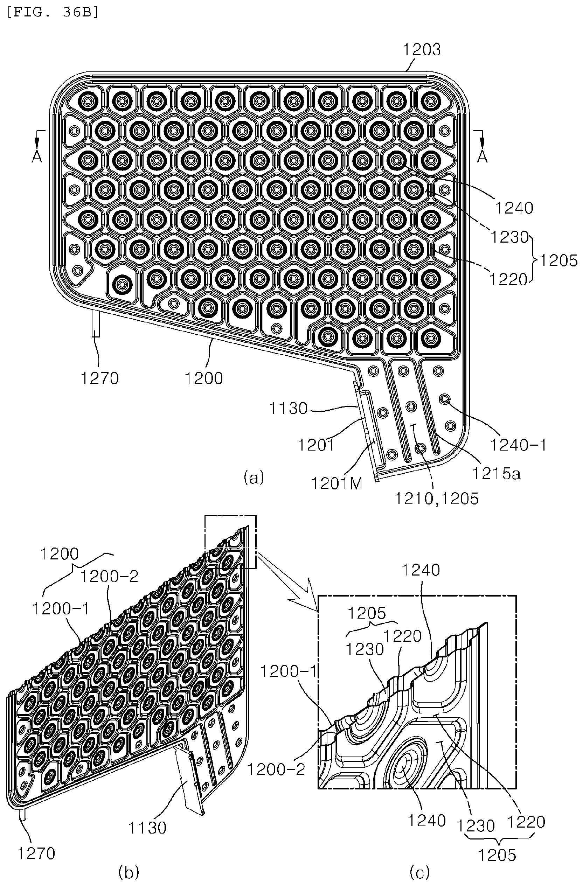

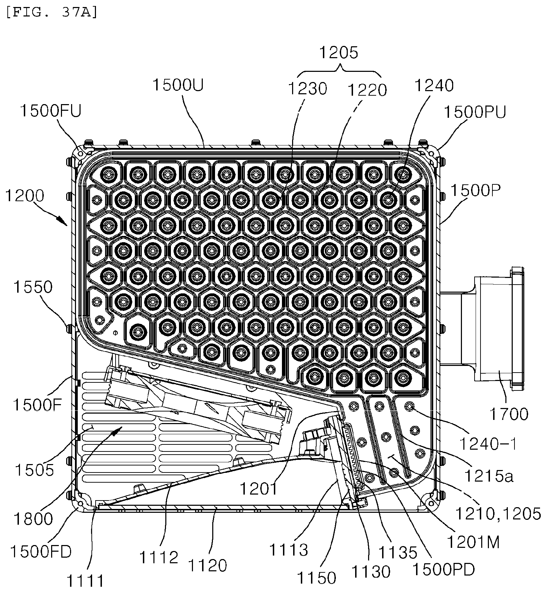

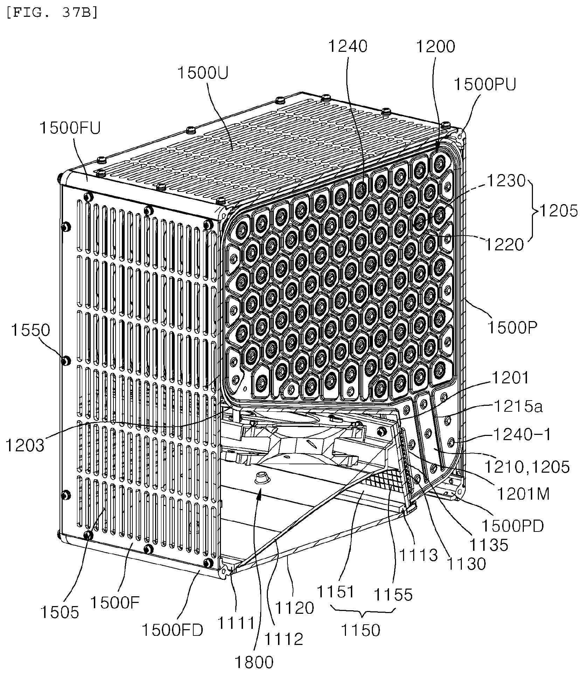

FIGS. 34A to 34C are perspective views from various directions of a heat dissipation unit according to a second implementation among the components of FIG. 19, FIGS. 35A to 35C are exploded perspective views of FIGS. 34A to 34C, FIG. 36A is a side view (a) of FIG. 34A, a cross-sectional view (b) taken along line A-A, and a partially enlarged view (c) thereof, FIG. 36B is a side view (a) of FIG. 34A, a cutaway perspective view (b) taken along line A-A, and a partially enlarged view (c) thereof, FIG. 37A is a vertical cross-sectional view taken along line B-B of FIG. 19, and FIG. 37B is a cutaway perspective view taken along line B-B of FIG. 19.

Each of the plurality of heat dissipation units 1200 according to the second implementation, as shown in FIGS. 34A to 37B, may include a refrigerant flow space 1205 filled with a refrigerant therein.

Here, the refrigerant flow space 1205 may include a first refrigerant flow path 1210 forming a press-fit end 1201, which is a coupling portion with the LED unit 1150, to be positioned relatively lower with respect to the direction of gravity, and configured to evaporate a liquid refrigerant of the refrigerant stored therein, and a second refrigerant flow path 1220 extending integrally toward a relatively upper side with respect to the direction of gravity to communicate with the first refrigerant flow path 1210 and forming a heat dissipation plate portion 1203 in which gas refrigerant phase-changed from the liquid refrigerant is diffused and condensed.

In this case, a portion of the refrigerant flow space 1205 including the press-fit end 1201 in which the first refrigerant flow path 1210 is formed and positioned relatively lower in the direction of gravity may be defined as an evaporation region (no reference numeral assigned). A portion of the refrigerant flow space 1205, excluding the evaporation region and positioned relatively upward in the direction of gravity, may be defined as a condensation region (no reference numeral assigned).

However, the evaporation region and the condensation region have meaning only as functional configurations distinguished in terms of phase change of the refrigerant. Since the distinction between the region in which evaporation of the refrigerant (i.e., phase change from liquid refrigerant to gas refrigerant) occurs and the region in which condensation of the refrigerant (i.e., phase change from gas refrigerant to liquid refrigerant) occurs may not be absolute, specific reference numerals are not assigned thereto.

In addition, as will be described later, the evaporation region may be defined as a portion adjacent to the press-fit end 1201, which is a portion directly connected to the heat transfer mediating block 1130 for mediating and transferring heat generated from the LED unit 1150 or to the above-described LED board mounting block 1151. The condensation region may be defined as all other portions excluding the evaporation region.

In the case of the heat dissipation unit 200 according to the first implementation, the press-fit end 201 side in the vertical direction where the first refrigerant flow path 210 is provided is defined as the evaporation region and the remaining portion corresponding to the evaporation plate portion 203 is defined as the condensation region. In contrast, in the heat dissipation unit 1200 according to the second implementation, a portion of the refrigerant flow space 1205 including the entire first refrigerant flow path 1210, which mainly serves as a reservoir for liquid refrigerant and corresponds to a relatively lower side in the direction of gravity, is defined as the evaporation region. Meanwhile, a portion of the refrigerant flow space 1205 including the second refrigerant flow path 1220 or the third refrigerant flow path 1230, which mainly serves as a region where gas refrigerant is diffused or liquid refrigerant condensed from the gas refrigerant flows downward and corresponds to a relatively upper side in the direction of gravity, is defined as the condensation region.

The refrigerant flow space 1205 constituting the evaporation region and the condensation region as described above may be formed by joining together one or more metal panel members made of SUS (stainless steel).

Meanwhile, the lighting apparatus 1000 according to an embodiment of the present disclosure may further include a lighting body 1110 for mediating installation of the LED unit 1150.

Here, the heat dissipation unit 1200 according to the second implementation may be disposed between a heat-generating surface of the LED unit 1150 and the press-fit end 1201 provided with the first refrigerant flow path 1210, and may further include a heat transfer mediating block 1130 configured to receive heat from the LED unit 1150 and transfer the heat to the press-fit end 1201.

In this case, a portion of the press-fit end 1201 provided with the first refrigerant flow path 1210 may be open to communicate with the refrigerant flow space 1205, and the heat transfer mediating block 1130 may be coupled to close the above-described opened press-fit end 1201.

Here, the heat transfer mediating block 1130 may be manufactured in two types having different thicknesses according to a thickness of the LED board mounting block 1151 of the LED unit 1150 (see reference numerals 1130-1 and 1130-2 in FIGS. 31A and 31B).

In addition, a plurality of heat transfer mediating blocks 1130 may be manufactured to have the same shape and thickness and may be provided to be in surface thermal contact with a rear surface of the LED board mounting block 1151. The number of heat transfer mediating blocks 1130 may correspond to the number of individual heat dissipation units 1200.

As described above, the heat transfer mediating block 1130 is coupled to the press-fit end 1201 side where the first refrigerant flow path 1210 is provided and performs a function of shielding the refrigerant flow space 1205 in an opened state. At the same time, in order to easily transfer heat delivered from the LED unit 1150 to the evaporation region side, when coupled to an insertion end 1201M formed at the press-fit end 1201, an end thereof may be disposed to protrude by a predetermined length into the refrigerant flow space 1205, and may come into contact with the liquid refrigerant stored in the first refrigerant flow path 1210 side of the refrigerant flow space 1205.

To this end, an uneven portion 1135 in which concave portions and convex portions are alternately and repeatedly formed in one direction may be further formed at an end of the heat transfer mediating block 1130.

As the uneven portion 1135 is formed such that concave and convex portions are alternately repeated, it substantially increases an area in contact with the liquid refrigerant at the evaporation region side, thereby increasing a heat transfer surface area and effectively increasing an amount of evaporation of the liquid refrigerant.

Therefore, the plurality of heat dissipation units 1200 may receive heat from the LED unit 1150 via the heat transfer mediating blocks 1130, each having one surface in contact with a heat-generating surface of the LED unit 1150 and the other surface formed with the uneven portion 1135 in thermal contact with the refrigerant flow space 1205.

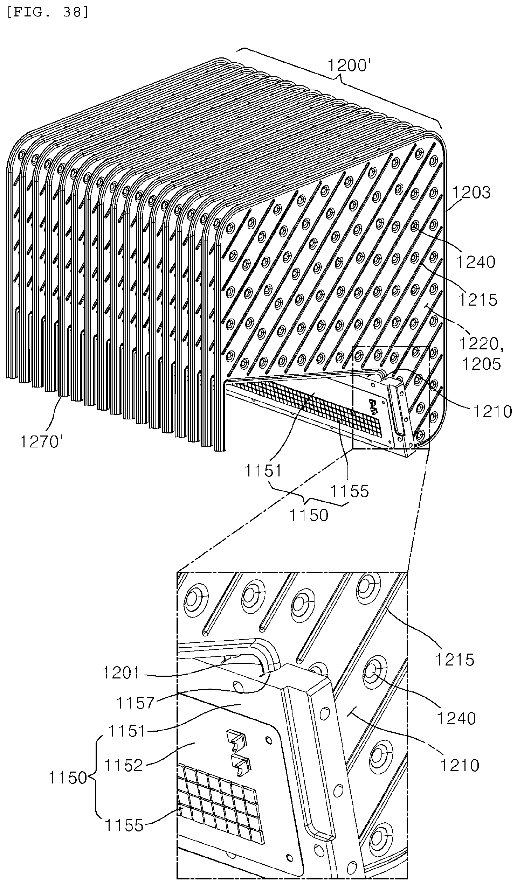

However, the heat transfer mediating block 1130 is not necessarily required. In the case of a heat dissipation unit 1200' implemented according to another embodiment of the present disclosure, as shown in FIGS. 38 and 39 to be described later, a press-fit end 1201, which is a peripheral edge, may be formed in a tapered shape and directly inserted and installed into an insertion slot 1157 formed in the LED board mounting block 1151 by a press-fitting method. In this case, provision of the heat transfer mediating block 1130 is unnecessary.

For reference, in order to stably fix the heat dissipation unit 1200' in an insertion slot 1157 formed in the LED board mounting block 1151, leakage of refrigerant may be prevented by performing solder bonding in a welding manner along a portion where the insertion slot 1157 and the press-fit end 1201 of the heat dissipation unit 1200' are in contact after the above-described press-fitting installation.

Meanwhile, the heat dissipation unit 1200 according to the second implementation may include two metal panel members. Specifically, it may include a one-side heat conduction panel 1200-1 having at least a predetermined level of thermal conductivity and simultaneously forming portions corresponding to the first refrigerant flow path 1210 and the second refrigerant flow path 1220 during sheet metal processing by a press die process, and an other-side heat conduction panel 1200-2 having the same thermal conductivity as the one-side heat conduction panel 1200-1 and simultaneously forming portions corresponding to the first refrigerant flow path 1210 and the second refrigerant flow path 1220 during sheet metal processing by the press die process.

In addition, the heat dissipation unit 1200 according to the second implementation may further include a plurality of strength reinforcing portions 1240 formed to protrude from the one-side heat conduction panel 1200-1 and the other-side heat conduction panel 1200-2 toward the refrigerant flow space 1205.

Here, when peripheral edges of the two metal panel members made of SUS (i.e., the one-side heat conduction panel 1200-1 and the other-side heat conduction panel 1200-2) are joined by a joining process, the plurality of strength reinforcing portions 1240 facing each other on the one-side heat conduction panel 1200-1 and the other-side heat conduction panel 1200-2 may be joined together and formed to protrude toward the refrigerant flow space 205 in which the liquid refrigerant and the gas refrigerant flow.

In terms of rigidity reinforcement of the one-side heat conduction panel 1200-1 and the other-side heat conduction panel 1200-2, the plurality of strength reinforcing portions 1240, formed by processing toward the refrigerant flow space 205 using a sheet metal die, serve to enhance shear strength compared to a case in which the panels are generally formed flat. In terms of gas-liquid circulation of the refrigerant filled in the refrigerant flow space 205, the strength reinforcing portions increase a contact area with the refrigerant (particularly the gas refrigerant), thereby facilitating active condensation and promoting gas-liquid circulation.

In this case, the strength reinforcing portions 1240 provided at a plurality of locations may be provided in the form of small circular dots, and may include a plurality of lower reinforcing portions 1240-1 formed in a portion (evaporation region) where the first refrigerant flow path 1210 is located, and a plurality of upper reinforcing portions 1240 (designated by the same reference numeral as the general strength reinforcing portions) formed in a portion (condensation region) where the second refrigerant flow path 1220 is located.

Here, the upper reinforcing portions 1240 formed in the condensation region may be densely and closely arranged over substantially the entire condensation region, whereas the lower reinforcing portions 1240-1 formed in the evaporation region may be arranged with relatively lower density and spaced apart compared to the upper reinforcing portions 1240 formed in the condensation region.

The reason for setting different densities of the plurality of strength reinforcing portions 1240 formed in the condensation region and the evaporation region is as follows.

First, since the plurality of upper reinforcing portions 1240 formed in the condensation region are densely and closely arranged over substantially the entire condensation region, the second refrigerant flow path 1220 and the third refrigerant flow path 1230 forming the refrigerant flow space 1205 to be described later are also formed densely and closely. Thus, during gas-liquid circulation (or phase change) of the refrigerant, shaking (or movement) between the one-side heat conduction panel 1200-1 and the other-side heat conduction panel 1200-2 due to changes in internal pressure may be appropriately prevented, and inherent rigidity may be reinforced by the upper reinforcing portions 1240, the second refrigerant flow path 1220, and the third refrigerant flow path 1230, which are formed during a sheet metal process by a press-forming method.

Next, the portions corresponding to the evaporation region are portions in which liquid refrigerant is stored. If they are densely joined using the lower reinforcing portion 1240-1 as in the condensation region, there is a concern that, when the refrigerant freezes, an increase in volume may cause damage to the joined portions. Thus, the portions corresponding to the evaporation region are joined after being relatively spaced apart from each other, so that stress is minimized during freezing of the refrigerant and volumetric expansion and contraction of the liquid refrigerant are allowed to some extent.

Meanwhile, the refrigerant flow space 1205 may include a second refrigerant flow path 1210 formed in a predetermined pattern shape by sheet metal processing, particularly around the strength reinforcing portions 1240 formed in the condensation region, and a third refrigerant flow path 1230 formed between the second refrigerant flow path 1210 and the strength reinforcing portions 1240, the third refrigerant flow path being formed by sheet metal processing in a shape recessed less than the strength reinforcing portions 1240.

In general, since a thickness of the second refrigerant flow path 1220 within the refrigerant flow space 1205 is formed to be relatively greater than that of the third refrigerant flow path 1230, when gas refrigerant is condensed into liquid refrigerant through heat exchange in the condensation region, the second refrigerant flow path serves to guide the flow such that the liquid refrigerant flowing downward in the direction of gravity due to surface tension or gravity is dispersed and collected toward the evaporation region.

Conversely, since the third refrigerant flow path 1230 has a relatively smaller thickness than the second refrigerant flow path 1220, when liquid refrigerant evaporates into gas refrigerant in the evaporation region, the evaporated gas refrigerant may be diffused and distributed throughout the entire condensation region through the relatively narrow third refrigerant flow path 1230, thereby promoting active heat exchange.

The above-described second refrigerant flow path 1220 and third refrigerant flow path 1230 are mainly formed in a predetermined pattern centered around the plurality of strength reinforcing portions 1240 densely formed in the condensation region. It should be noted that, on the evaporation region side, the second refrigerant flow path 1220 and the third refrigerant flow path 1230 are not separately distinguished and formed, since the evaporation region is mainly involved in the storage of the liquid refrigerant and its evaporation (phase change to gas refrigerant).

However, on the evaporation region side, at least one refrigerant distribution guide 1215a may be formed to disperse and collect the refrigerant that has been condensed in the condensation region and flows downward in the direction of gravity. The refrigerant distribution guide 1215a may be formed to be spaced apart substantially in parallel with the press-fit end 1201 coupled to the LED unit 1150. In addition, it is preferable that the refrigerant distribution guides 1215a be formed to be spaced apart from each other by a predetermined distance within the refrigerant flow space 1205.

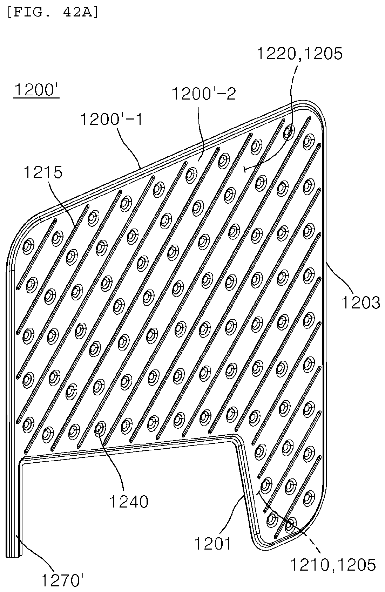

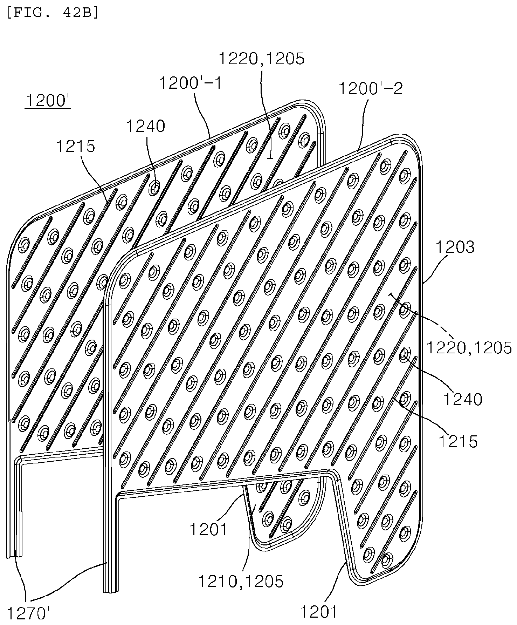

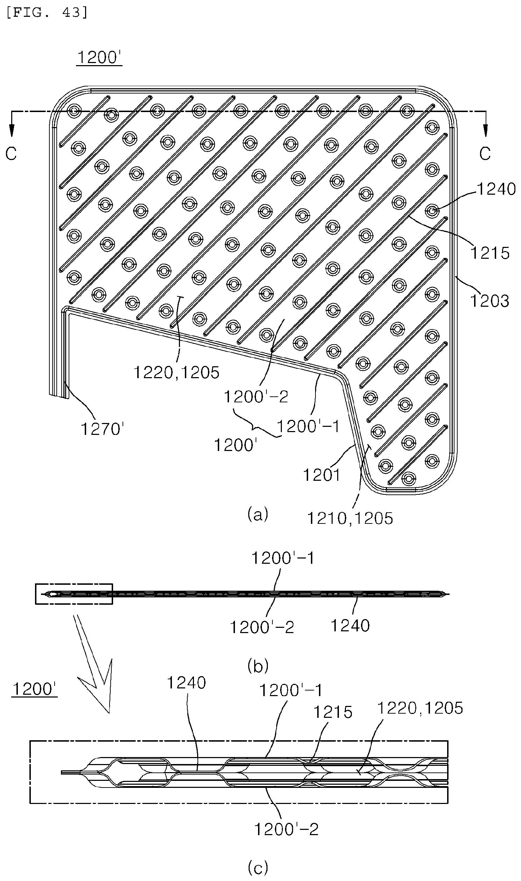

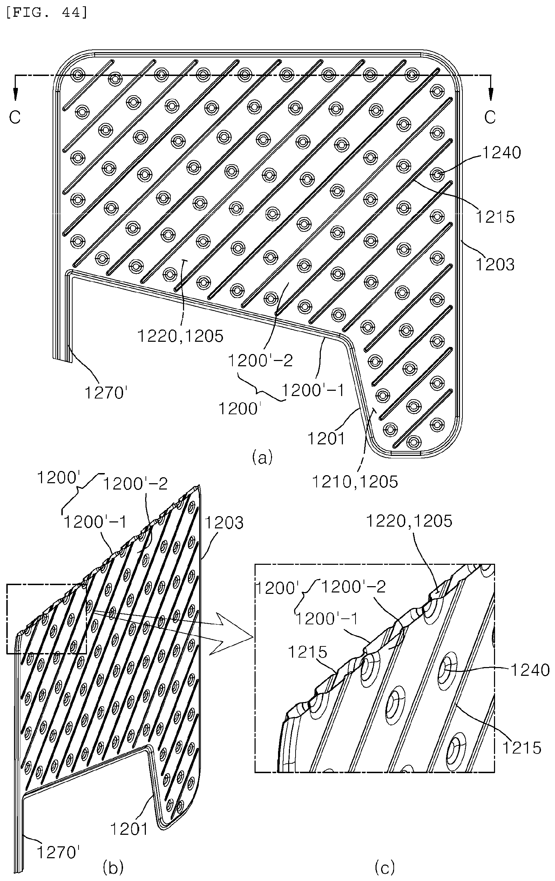

FIG. 38 is a perspective view illustrating a lighting apparatus to which a heat dissipation unit according to a third implementation is applied among the components of FIGS. 30A and 30B, and a partially enlarged view thereof, FIG. 39 is an exploded perspective view of FIG. 38, FIG. 40 is a perspective view illustrating a coupled state of the heat dissipation unit to the LED unit, FIG. 41 is a cutaway perspective view of FIG. 40, FIG. 42A is a perspective view illustrating a single heat dissipation unit among the components of FIG. 38, FIG. 42B is an exploded perspective view of FIG. 42A, FIG. 43 is a side view (a) of FIG. 42A, a cross-sectional view (b) taken along line C-C, and a partially enlarged view (c) thereof, FIG. 44 is a side view (a) of FIG. 42A, a cutaway perspective view (b) taken along line C-C, and a partially enlarged view (c) thereof.

In embodiments of the present disclosure, the heat dissipation unit is not limited to being implemented only as the first implementation 200 and the second implementation 1200 as shown in FIGS. 4A to 15 and FIGS. 24A to 37B.

For example, in a heat dissipation unit 1200' according to the third implementation, as shown in FIGS. 38 and 39 and FIGS. 42A to 44, the plurality of strength reinforcing portions 1240 may be formed to be uniformly and arranged at intervals over both the evaporation region and the condensation region. In addition, the refrigerant flow space 1205 may be implemented in another embodiment in which a plurality of inclined guides 1215 are formed at an inclination to guide the flow of condensed liquid refrigerant toward a peripheral edge (limited to a peripheral edge of the condensation region) provided relatively on a lower side in the direction of gravity.

The plurality of inclined guides 1215 are formed to be inclined with respect to the direction of gravity, thereby serving to guide the flow of liquid refrigerant flowing directly downward so that it is uniformly distributed and allowed to flow downward overall.

Meanwhile, in the present disclosure, the heat dissipation units according to the first implementation 200, the second implementation 1200, and a fourth implementation 1200" to be described later may further include air vent tubes 270, 1270, and 1270", respectively.

In the first implementation 200, the second implementation 1200, and the fourth implementation 1200" to be described later, the air vent tubes 270, 1270, and 1270" may be installed on an outer surface of either one of the one-side heat conduction panels 200-1, 1200-1, 1200"-1 and the other-side heat conduction panels 200-2, 1200-2, 1200"-2.

Such air vent tubes 270, 1270, and 1270" may serve to evacuate the refrigerant flow space before or after refrigerant is injected.

In the heat dissipation unit 1200 implemented according to the second implementation of the present disclosure as shown in FIGS. 19 to 37B, the air vent tube 1270 may be separately manufactured and then detachably installed in an air vent hole 1260 formed in either the one-side heat conduction panel 1200-1 or the other-side heat conduction panel 1200-2 via a welding auxiliary ring 1275.

More specifically, the air vent tube 1270 may be installed to communicate with the air vent hole 1260. Before the one-side heat conduction panel 1200-1 and the other-side heat conduction panel 1200-2 are joined together, the air vent tube may be installed to pass through the air vent hole 1260 from an inner side corresponding to the refrigerant flow space 1205 to an outer side and to protrude outward.

At this time, an inner end of the air vent tube 1270 may be formed in a locking end shape (not shown). After the locking end of the air vent tube 1270 is engaged with and coupled to an inner side of the one-side heat conduction panel 1200-1 or the other-side heat conduction panel 1200-2 in which the air vent hole 1260 is formed, the welding auxiliary ring 1275 is fitted from the outside to increase a welding surface, and then the air vent tube 1270 is fixed by a welding method.

Before welding fixation, the air vent tube 1270 may be cut to match an outer end surface of the welding auxiliary ring 1275, and then welding may be performed such that the air vent hole 1260 and a hollow portion of the air vent tube 1270 are simultaneously sealed.

However, in the heat dissipation unit 1200' according to the third implementation, as shown in FIGS. 38 and 39 and FIGS. 42A to 44, the air vent tube 1270' is not separately manufactured. Instead, when the one-side heat conduction panel 1200'-1 and the other-side heat conduction panel 1200'-2 are manufactured by a sheet metal process using a press die method, the air vent tube may be additionally formed to extend outward by a predetermined length so as to communicate with the refrigerant flow space 1205.

Meanwhile, the heat dissipation unit according to the present disclosure is not limited to the one embodiment 1200 and another embodiment 1200' described above, and may be implemented as yet another embodiment 2200, as shown in FIGS. 40 and 41.

More specifically, referring to FIGS. 40 and 41, the heat dissipation unit 2200 according to another embodiment of the present disclosure may include a plurality of strength reinforcing portions 2240 formed on a one-side heat conduction panel 2200-1 and an other-side heat conduction panel 2200-2. Without providing the plurality of inclined guides 1215 included in the heat dissipation unit 2200 according to the above-described other embodiment, the heat dissipation unit may be configured to guide the flow of condensed liquid refrigerant within the refrigerant flow space 2205 through a patterned arrangement of the plurality of strength reinforcing portions 2240.

Here, as shown in FIG. 41, in the heat dissipation unit 2200 according to another embodiment of the present disclosure, a portion where the press-fit end 1201 is formed may be solder-bonded in a welding manner to a plurality of press-fit portions 2117 protruding by a predetermined length from a mounting panel 1113 of the lighting body 2110 (or, in the case of the heat dissipation unit 1200' according to another embodiment of the present disclosure shown in FIGS. 38 and 39, from the LED board mounting block 1151) toward a rear side corresponding to the heat dissipation unit 2200.

The heat dissipation unit 2200 according to still another embodiment of the present disclosure is installed in the same manner as the heat dissipation unit 1200 according to another embodiment of the present disclosure shown in FIGS. 38 and 39, namely, by being press-fitted into the insertion slot 2118 formed in the mounting panel 2113 of the lighting body 2110.

However, in the case of the heat dissipation unit 1200 according to another embodiment of the present disclosure, as shown in FIGS. 38 and 39, the insertion slot 1157 is provided in a form in which a portion of the mounting panel 1113 is cut. In contrast, the insertion slot 2118 for fixed installation of the heat dissipation unit 2200 according to still another embodiment of the present disclosure differs in that the insertion slot 2118 described above is formed inside the plurality of press-fit portions 2117 protruding rearward from the mounting panel 2113.

Here, an epoxy bonding method may be applied in which epoxy molding is injected between a front surface of the mounting panel 2113 and an LED board mounting block (no reference numeral assigned) of the LED unit 2150, and then joined.

In addition, before the heat dissipation unit 2200 according to still another embodiment of the present disclosure is inserted and fixed into the insertion slot 2118 of the mounting panel 2113 by a press-fitting method, an epoxy bonding method may also be applied in which epoxy molding is injected into the insertion slot 2118 and then joined.

In the case where the insertion slot 2118 is fixed by the epoxy bonding method as described above, since a welding coupling method is excluded, thermal deformation may be prevented in advance when an absorber 2300, additionally installed on the first refrigerant flow path 2210 to promote evaporation of the liquid refrigerant, is fixed by a welding coupling method.

In addition, the epoxy bonding method in the heat dissipation unit 2200 according to still another embodiment of the present disclosure serves to ensure that heat generated from the LED unit 2150 is transmitted, via the mounting panel 2113, to the first refrigerant flow path 2210 corresponding to the press-fit end 2201 of the heat dissipation unit 2200 while maintaining a high heat transfer rate.

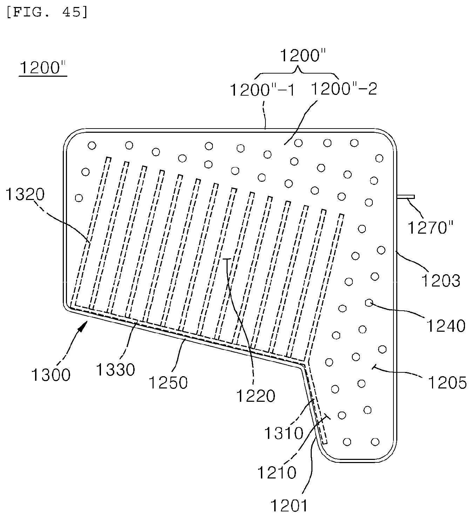

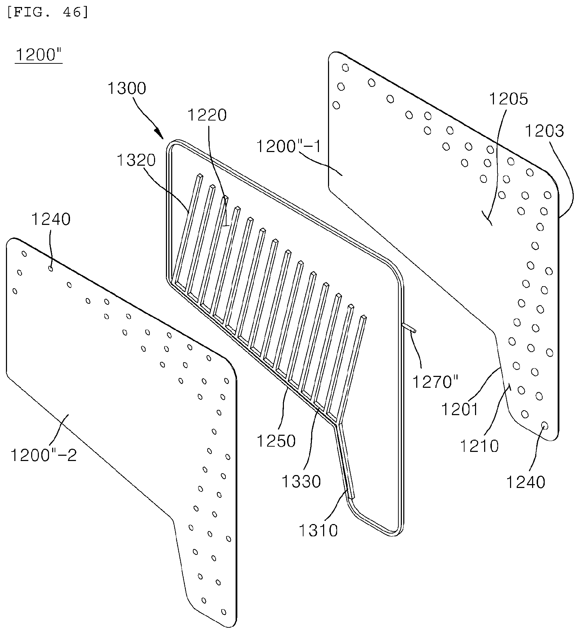

FIG. 45 is an internal perspective view (side view) illustrating a heat dissipation unit according to a fourth implementation among the components of FIGS. 28A and 28B, and FIG. 46 is an exploded perspective view of FIG. 45.

In the lighting apparatus 100 according to an embodiment of the present disclosure, as shown in FIGS. 45 and 46, the heat dissipation unit 1200" may be implemented according to the fourth implementation.

More specifically, the heat dissipation unit 1200" according to the fourth implementation may further include an absorber 1300 disposed on the refrigerant flow space 1205.

The absorber 1300 is generally disposed on the first refrigerant flow path 1210 and serves to promote evaporation of liquid refrigerant of the refrigerant by heat supplied from the LED unit 1150.

Here, the absorber 1300 may be provided as either a braided body formed by braiding thermally conductive metal wires or a sintered body formed by sintering metal powder of a predetermined material.

When the absorber 1300 is provided as the sintered body, the absorber disposed close to the press-fit end 1201 corresponding to the evaporation region may be defined as an evaporation-portion sintered body 1310. A plurality of absorbers disposed on the evaporation plate portion 1203 corresponding to the condensation region may be defined as sintered-body columns 1320, and an absorber connecting lower ends of the plurality of sintered-body columns 1320 may be defined as a sintered-body base 1330.

Here, the plurality of sintered-body columns 1320 may be coupled to an inner surface of the refrigerant flow space 1205 via the sintered-body base 1330 connecting one end (lower end) of each of the sintered-body columns.

In this case, the evaporation-portion sintered body 1310, the plurality of sintered-body columns 1320, and the sintered-body base 1330 may be limited to being made of SUS as a material constituting the above-described metal powder.

Meanwhile, the one-side heat conduction panel 1200"-1 and the other-side heat conduction panel 1200"-2 may be stacked and joined by a welding method. The welding method here may include laser welding in addition to general welding coupling.

However, the coupling method of the one-side heat conduction panel 1200"-1 and the other-side heat conduction panel 1200"-2 is not limited to the above-described welding method, and a brazing method for stacked joining is not excluded.

Meanwhile, peripheral edges of the one-side heat conduction panel 1200"-1 and the other-side heat conduction panel 1200"-2 that contact each other may be joined by a butt welding method. Alternatively, as shown in FIGS. 45 and 46, a welding frame 1250 corresponding to the peripheral edges of the one-side heat conduction panel 1200"-1 and the other-side heat conduction panel 1200"-2 may be further provided, and the evaporation-portion sintered body 1310, the plurality of sintered-body columns 1320, and the sintered-body base 1330 may be welded together with the one-side heat conduction panel 1200"-1 and the other-side heat conduction panel 1200"-2 via the welding frame 1250.

Meanwhile, in the lighting apparatuses 100 and 1000 according to the embodiments of the present disclosure, when the metal panel members constituting the heat dissipation units 200, 1200, 1200', and 1200" according to the first to fourth implementations are made of SUS (stainless steel), water may be employed as the refrigerant, unlike in the case where the material is aluminum (including aluminum alloys). This is because, unlike aluminum, even when water is used as the refrigerant, there is little or no chemical reaction occurring inside.

According to the lighting apparatuses 100 and 1000 according to the embodiments of the present disclosure having combinations of the above-described configurations, even when the heat-generating surface of the LED unit 1150 is formed in a relatively narrow region, efficient heat dissipation may be achieved by the plurality of heat dissipation units 200, 1200, 1200', and 1200" extending relatively upward in the direction of gravity. Thus, not only may light distribution performance be improved, but also reduction of product lifespan may be prevented.

As described above, a lighting apparatus according to embodiments of the present disclosure has been described in detail with reference to the accompanying drawings. However, embodiments of the present disclosure are not necessarily limited to the above-described embodiments, and it will be apparent that various modifications and equivalent implementations are possible by those skilled in the art. Therefore, the true scope of the present disclosure is defined by the claims set forth below.

### [Industrial Applicability]

The present disclosure provides a lighting apparatus capable of maximizing heat dissipation performance by including a heat dissipation unit that can effectively dissipate heat generated from an LED unit.

## Claims

1. A lighting apparatus comprising:
an LED unit having a plurality of LED elements mounted on one surface of opposite surfaces to define a light-emitting surface from which light is radiated, the other surface defining a heat-generating surface to release a predetermined amount of heat;
a plurality of heat dissipation units respectively disposed vertically in an up-and-down direction along a direction of gravity with respect to the heat-generating surface of the LED unit, spaced apart from each other by a predetermined distance in a left-and-right direction, and having a refrigerant flow space formed therein and filled with a phase-changeable refrigerant; and
a lighting body in which the LED unit and the plurality of heat dissipation units are installed and which is opened at a portion in the direction of the light-emitting surface.

2. The lighting apparatus of claim 1, wherein the plurality of heat dissipation units receive heat from the LED unit via the lighting body in which the LED unit is installed and in which a plurality of press-fit portions are formed to extend in an up-and-down direction at positions corresponding to the heat-generating surface.

3. The lighting apparatus of claim 2, wherein the plurality of heat dissipation units are press-fitted and fixed to the press-fit portions such that at least a portion of the refrigerant flow space is positioned inside the plurality of press-fit portions provided with a pair of slot ribs.

4. The lighting apparatus of claim 1, wherein the plurality of heat dissipation units receive heat from the LED unit via a heat transfer mediating block having one surface in contact with the LED unit and the other surface provided with an uneven portion that is in thermal contact with the refrigerant flow space.

5. The lighting apparatus of claim 4, wherein the uneven portion of the heat transfer mediating block is inserted from the outside toward the refrigerant flow space and is in contact with liquid refrigerant filled in the refrigerant flow space.

6. The lighting apparatus of any one of claims 1 to 5, wherein the refrigerant flow space of the plurality of heat dissipation units comprises:
a first refrigerant flow path constituting an evaporation region that evaporates liquid refrigerant of refrigerant filled therein by heat transferred from the LED unit; and
a plurality of second refrigerant flow paths provided in a condensation region in which gas refrigerant evaporated from the first refrigerant flow path diffuses and is condensed through heat exchange with outdoor air, the plurality of second refrigerant flow paths guiding a flow of the condensed liquid refrigerant toward the first refrigerant flow path.

7. The lighting apparatus of claim 6,
wherein the plurality of heat dissipation units comprise:
a one-side heat conduction panel forming one side surface of the refrigerant flow space; and
an other-side heat conduction panel forming the other side surface of the refrigerant flow space,
wherein the one-side heat conduction panel and the other-side heat conduction panel form the refrigerant flow space by bending and joining a single metal panel member, or form the refrigerant flow space by joining two metal panel members.

8. The lighting apparatus of claim 7, wherein the metal panel members forming the one-side heat conduction panel and the other-side heat conduction panel are made of SUS (stainless steel).

9. The lighting apparatus of claim 8, wherein, when the metal panel members forming the one-side heat conduction panel and the other-side heat conduction panel are made of SUS, the refrigerant is water.

10. The lighting apparatus of claim 7,
wherein the plurality of heat dissipation units further comprise a plurality of strength reinforcing portions formed to protrude from the one-side heat conduction panel and the other-side heat conduction panel toward the refrigerant flow space, and
wherein the plurality of strength reinforcing portions are joined to each other within the refrigerant flow space when the one-side heat conduction panel and the other-side heat conduction panel are joined together.

11. The lighting apparatus of claim 8, wherein the plurality of heat dissipation units further comprise an absorber disposed on the first refrigerant flow path in the refrigerant flow space to promote evaporation of liquid refrigerant of the refrigerant by heat supplied from the LED unit.

12. The lighting apparatus of claim 11, wherein the absorber is provided as either a braided body formed by braiding thermally conductive metal wires or a sintered body formed by sintering metal powder of a predetermined material.

13. The lighting apparatus of claim 12, wherein, when the absorber is provided as the sintered body, the metal powder forming the sintered body is made of SUS, which forms the one-side heat conduction panel and the other-side heat conduction panel.

14. The lighting apparatus of claim 8, wherein the plurality of heat dissipation units further comprise an air vent tube for vacuumizing the refrigerant flow space before or after the refrigerant is injected into the refrigerant flow space.

15. The lighting apparatus of claim 14, wherein the air vent tube is coupled to either the one-side heat conduction panel or the other-side heat conduction panel, or is integrally formed with the one-side heat conduction panel and the other-side heat conduction panel.

16. The lighting apparatus of claim 1, further comprising:
a finger guard panel assembly configured to cover the plurality of heat dissipation units except for the light-emitting surface of the LED unit, the finger guard panel assembly having a plurality of ventilation holes formed through which outdoor air is ventilated to enable heat exchange with the plurality of heat dissipation units.
